# EUROPEAN PATENT APPLICATION

(11) **EP 4 794 502 A1**
(43) Date of publication of application: **19.08.2026**
(21) Application number: 26151820.3
(22) Date of filing: 14.01.2026
(51) Int. Cl.: H10K 59/80, H10K 59/121, H10K 59/38

(54) **DISPLAY DEVICE AND ELECTRONIC DEVICE**

(30) Priority: 18.02.2025 KR 20250020584
(71) Applicant: Samsung Display Co., Ltd., Yongin-si, Gyeonggi-do 17113 (KR)
(72) Inventor: Lee, Cheon Myeong, Yongin-si, Gyeonggi-do (KR); Kim, Gun Shik, Yongin-si, Gyeonggi-do (KR); Baek, Soo Min, Yongin-si, Gyeonggi-do (KR); Ha, Ju Hwa, Yongin-si, Gyeonggi-do (KR)
(74) Representative: Gulde & Partner

(57) **Abstract**

A display device includes a substrate (SSUB), a first electrode (AND) on the substrate (SSUB), a pixel defining layer (PDL) located on the first electrode (AND) and having an emission area (EA) exposing the first electrode (AND), a light emitting stack (IL) located on the emission area (EA), first to m^{th} layers (L1 - Lm) sequentially arranged on the light emitting stack (IL) and the pixel defining layer (PDL), an overcoat layer (OC) located on the m^{th} layer (Lm), and a cover layer (CV) located on the overcoat layer (OC). The m^{th} layer (Lm) includes a sub-lens (SLS), and the m is a natural number greater than 1, and a final distance (Dtotb) from a center portion (EC) of the emission area (EA) to a center (SC) of the sub-lens (SLS) in a lateral direction has a value calculated based on a preset correction value and a sum of lateral movement amounts of first to m^{th} lights (LL1 - LLm) in the first to m^{th} layers (L1 - Lm) when the sub-lens (SLS) is located at a preliminary position (Dtota).

## Description

### BACKGROUND

### 1. Technical Field

The present disclosure relates to a display device, and more particularly, to a display device and an electronic device capable of improving luminance.

### 2. Description of the Related Art

A head mounted display (HMD) is an image display device that is worn on a user's head in the form of glasses or helmets to form a focus at a close distance in front of the user's eyes. The head mounted display may implement virtual reality (VR) or augmented reality (AR).

The head mounted display magnifies an image displayed on a small display device by using a plurality of lenses, and displays the magnified image. Therefore, the display device applied to the head mounted display needs to provide high-resolution images, for example, images with a resolution of 3000 PPI (Pixels Per Inch) or higher. To this end, an organic light emitting diode on silicon (OLEDoS), which is a high-resolution small organic light emitting display device, is used as the display device applied to the head mounted display. The OLEDoS is an image display device in which an organic light emitting diode (OLED) is located on a semiconductor wafer substrate on which a complementary metal oxide semiconductor (CMOS) is located.

### SUMMARY

Aspects of present disclosure provide a display device and an electronic device capable of improving luminance.

According to one embodiment of the present disclosure, there is provided a display device including: a substrate; a first electrode on the substrate; a pixel defining layer located on the first electrode and having an emission area exposing the first electrode; a light emitting stack located on the emission area; first to m^{th} layers sequentially arranged on the light emitting stack and the pixel defining layer; an overcoat layer located on the m^{th} layer; and a cover layer located on the overcoat layer, where the m^{th} layer includes a sub-lens, and the m is a natural number greater than 1, and a final distance from a center portion of the emission area to a center of the sub-lens in a lateral direction has a value calculated based on a preset correction value and a sum of lateral movement amounts of first to m^{th} lights in the first to m^{th} layers when the sub-lens is located at a preliminary position.

According to another embodiment of the present disclosure, there is provided an electronic device including: a display device providing a screen, where the display device includes: a substrate; a first electrode on the substrate; a pixel defining layer located on the first electrode and having an emission area exposing the first electrode; a light emitting stack located on the emission area; first to m^{th} layers sequentially arranged on the light emitting stack and the pixel defining layer; an overcoat layer located on the m^{th} layer; and a cover layer located on the overcoat layer, where the m^{th} layer includes a sub-lens, and the m is a natural number greater than 1, and a final distance from a center portion of the emission area to a center of the sub-lens in a lateral direction has a value calculated based on a preset correction value and a sum of lateral movement amounts of first to m^{th} lights in the first to m^{th} layers when the sub-lens is located at a preliminary position.

The final distance from the center portion of the emission area to the center of the sub-lens may have a value of a product of the preset correction value and the sum of the lateral movement amounts of the first to m^{th} lights when the sub-lens is located at the preliminary position.

The preset correction value may be 0.85 to 0.90.

A lateral movement amount of k^{th} light in a k^{th} layer may have a value of a product of a thickness of the k^{th} layer and a tangent value for an incident angle of the k^{th} light in the k^{th} layer, and the k is a natural number that may have any value from 1 to m.

The lateral movement amount of the k^{th} light may be a lateral movement amount of the k^{th} light traveling from a bottom surface to a top surface of the k^{th} layer.

The incident angle of the k^{th} light may be an angle between a direction of the k^{th} light and a direction perpendicular to the lateral direction.

The incident angle of the k^{th} light may have a value calculated based on a target emission angle of an emission light emitted from the cover layer to an outside of the cover layer, refractive indices of the k^{th} to m^{th} layers, and incident angles of (k+1)^{th} to m^{th} lights in the (k+1)^{th} to m^{th} layers.

The m^{th} layer may comprises a base layer; and the sub-lens located on the base layer.

A thickness of the m^{th} layer may be a sum of a thickness of the base layer and a thickness of the sub-lens at the center of the sub-lens.

The display device may further comprise a second electrode located between the light emitting stack and the first layer.

The first to the m^{th} layers may have different refractive indices.

The first to the m^{th} layers, the overcoat layer and the cover layer may have different refractive indices.

The substrate may be a semiconductor substrate.

The first to the m^{th} layers may comprise an encapsulation layer, an adhesive layer on the encapsulation layer, and a color filter on the adhesive layer.

The sub-lens may be a micro-lens.

The display device may further comprise a lens on the cover layer.

The electronic device comprises or may be a smartphone, a tablet PC, a laptop, a TV, a desk monitor, smart glasses, a smart watch, a head mounted display or a vehicle.

According to one embodiment, the luminance of the display device and the electronic device may be improved.

For example, since a distance between an emission area of a sub-pixel and a sub-lens (e.g., a shift amount of the sub-lens) is optimized by a correction value, an emission angle of light emitted from the sub-pixel to the outside of the display panel may be optimized. Accordingly, more light may be emitted from each sub-pixel of the display panel at the emission angle of each sub-pixel, thereby effectively improving the luminance of the display panel.

The effects of the present disclosure are not limited to the above-described effects and other effects which are not described herein will become apparent to those skilled in the art from the following description.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present disclosure.

### BRIEF DESCRIPTION OF THE DRAWINGS

The above and other aspects and features of the present disclosure will become more apparent by describing in detail exemplary embodiments thereof with reference to the attached drawings, in which:
FIG. 1 is an exploded perspective view showing a display device according to one embodiment;
FIG. 2 is a block diagram illustrating a display device according to one embodiment;
FIG. 3 is an equivalent circuit diagram of a first sub-pixel according to one embodiment;
FIG. 4 is a layout diagram illustrating an example of a display panel according to one embodiment;
FIG. 5 is a layout diagram showing an example of the display area of FIG. 4;
FIG. 6 is a layout diagram showing another example of the display area of FIG. 4;
FIG. 7 is a cross-sectional view illustrating an example of a display panel taken along line I1-I1' of FIG. 5;
FIG. 8 is a cross-sectional view of a display device according to one embodiment;
FIG. 9 is a cross-sectional view of a display device according to one embodiment for describing a shift amount of a sub-lens;
FIG. 10 is a diagram for describing a final position of the sub-lens;
FIG. 11 is a block diagram of an electronic device according to one embodiment; and
FIGS. 12, 13 and 14 are schematic diagrams illustrating electronic devices according to various embodiments.

### DETAILED DESCRIPTION

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification. In the attached figures, the thickness of layers and regions is exaggerated for clarity.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the present disclosure may be combined partially or totally. As will be clearly appreciated by those skilled in the art, technically various interactions and operations are possible. Various embodiments can be practiced individually or in combination.

Hereinafter, specific exemplary embodiments will be described with reference to the accompanying drawings.

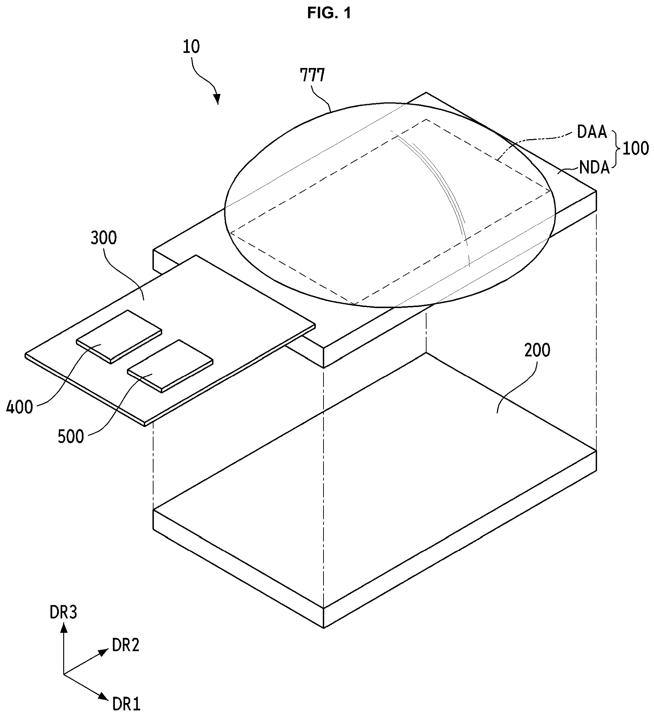

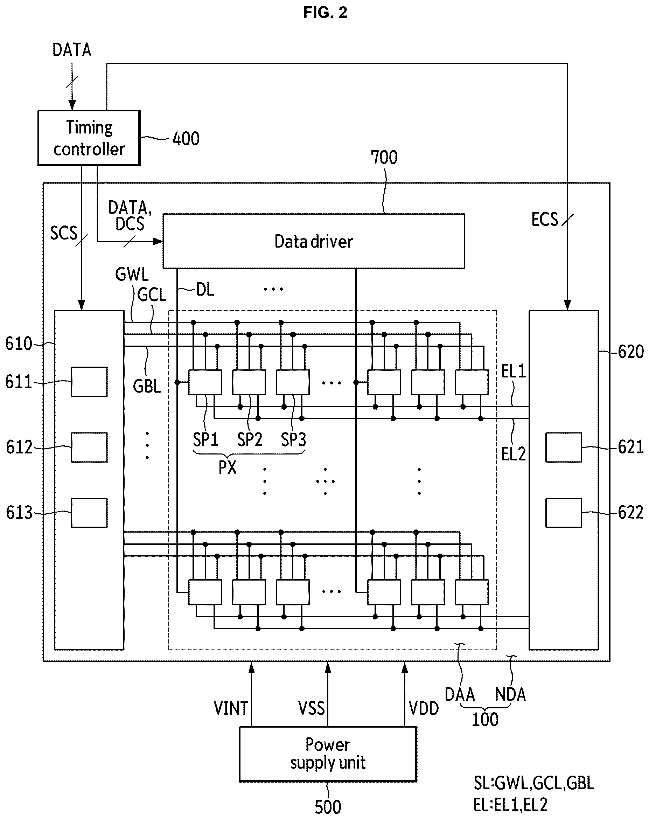

FIG. 1 is an exploded perspective view showing a display device according to one embodiment. FIG. 2 is a block diagram illustrating a display device according to one embodiment.

Referring to FIGS. 1 and 2, a display device 10 according to one embodiment is a device displaying a moving image or a still image. The display device 10 according to one embodiment may be applied to portable electronic devices such as a mobile phone, a smartphone, a tablet personal computer, a mobile communication terminal, an electronic organizer, an electronic book, a portable multimedia player (PMP), a navigation system, an ultra mobile PC (UMPC) or the like. For example, the display device 10 according to one embodiment may be applied as a display unit of a television, a laptop, a monitor, a billboard, or an Internet-of-Things (IoT) terminal. Alternatively, the display device 10 according to one embodiment may be applied to a smart watch, a watch phone, a head mounted display (HMD) for implementing virtual reality and augmented reality, and the like.

The display device 10 according to one embodiment may include a display panel 100, a heat dissipation layer 200, a circuit board 300, a timing control circuit 400, a power supply circuit 500, and a first lens 777.

The display panel 100 may have a planar shape similar to a quadrilateral shape. For example, the display panel 100 may have a planar shape similar to a quadrilateral shape, having a short side of a first direction DR1 and a long side of a second direction DR2 intersecting the first direction DR1. In the display panel 100, a corner where a short side in the first direction DR1 and a long side in the second direction DR2 meet may be right-angled or rounded with a selected curvature. The planar shape of the display panel 100 is not limited to a quadrilateral shape, and may be a shape similar to another polygonal shape, a circular shape, or an elliptical shape. The planar shape of the display device 10 may conform to the planar shape of the display panel 100, but the embodiment of the present disclosure is not limited thereto.

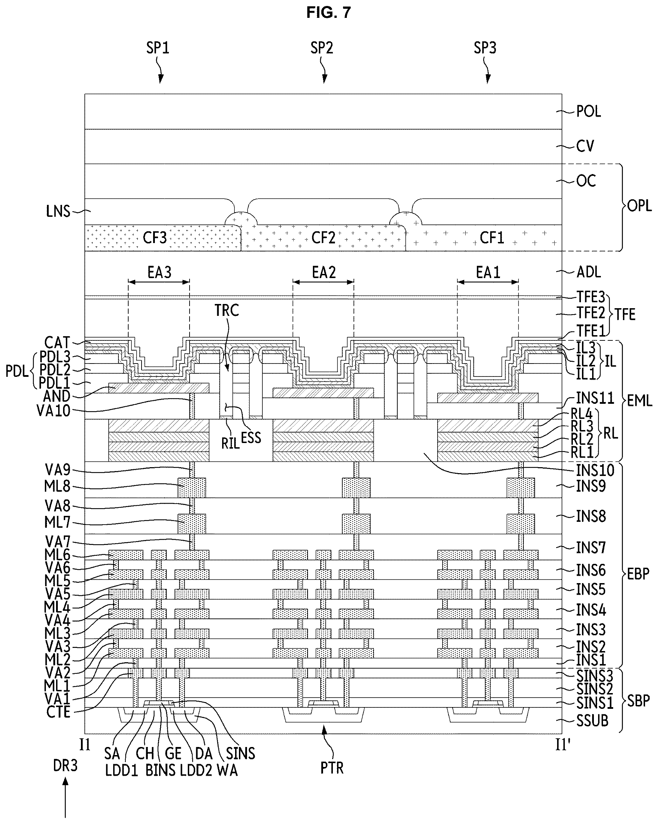

The display panel 100 includes a plurality of pixels PX, a plurality of scan lines SL, a plurality of emission control lines EL, a plurality of data lines DL, a scan driver 610, an emission driver 620, and a data driver 700. The display panel 100 may be divided into a display area DAA displaying an image and a non-display area NDA not displaying an image. For example, a substrate (e.g., a semiconductor substrate SSUB of FIG. 7) of the display panel 100 may include the display area DAA and the non-display area NDA.

The plurality of pixels PX may be arranged in the display area DAA. The plurality of pixels PX may be arranged in a matrix form in the first direction DR1 and the second direction DR2. The plurality of scan lines SL and the plurality of emission control lines EL may extend in the first direction DR1, while being arranged in the second direction DR2. The plurality of data lines DL may extend in the second direction DR2, while being arranged in the first direction DR1.

The plurality of scan lines SL include a plurality of write scan lines GWL, a plurality of control scan lines GCL, and a plurality of bias scan lines GBL. The plurality of emission control lines EL include a plurality of first emission control lines ECL1 and a plurality of second emission control lines ECL2.

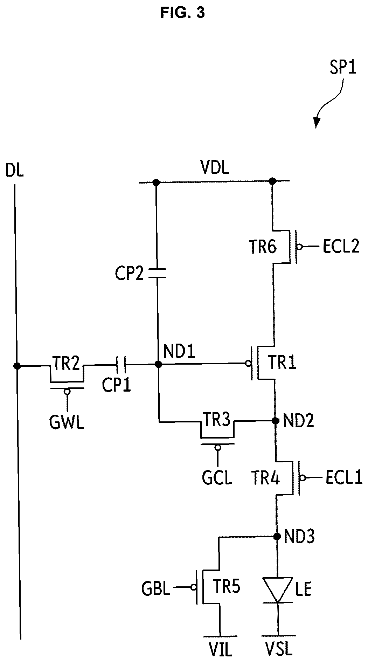

The plurality of pixels PX include a plurality of sub-pixels SP1, SP2, and SP3. The plurality of sub-pixels SP1, SP2, and SP3 may include a plurality of pixel transistors as shown in FIG. 3, and the plurality of pixel transistors may be formed by a semiconductor process and arranged on a semiconductor substrate SSUB (see FIG. 7). For example, the plurality of pixel transistors of the data driver 700 may be formed as complementary metal oxide semiconductor (CMOS) transistors, but the embodiment of the present disclosure is not limited thereto.

Each of the plurality of sub-pixels SP1, SP2, and SP3 may be connected to one write scan line GWL, one control scan line GCL, one bias scan line GBL, one first emission control line ECL1, one second emission control line ECL2, and one data line DL. Each of the plurality of sub-pixels SP1, SP2, and SP3 may receive a data voltage of the data line DL in response to a write scan signal of the write scan line GWL, and emit light from the light emitting element according to the data voltage.

The scan driver 610, the emission driver 620, and the data driver 700 may be located in the non-display area NDA.

The scan driver 610 includes a plurality of scan transistors, and the emission driver 620 includes a plurality of light emitting transistors. The plurality of scan transistors and the plurality of light emitting transistors may be formed on the semiconductor substrate SSUB (see FIG. 7) through a semiconductor process. For example, the plurality of scan transistors and the plurality of light emitting transistors may be formed as CMOS transistors, but the embodiment of the present disclosure is not limited thereto.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to the bias scan lines GBL.

The emission driver 620 includes a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output them to the first emission control lines ECL1. The second emission control driver 622 may generate second emission control signals according to the emission timing control signal ECS and sequentially output them to the second emission control lines EL2.

The data driver 700 may include a plurality of data transistors, and the plurality of data transistors may be formed on the semiconductor substrate SSUB (see FIG. 7) through a semiconductor process. For example, the plurality of data transistors may be formed as CMOS transistors, but the embodiment of the present disclosure is not limited thereto.

The data driver 700 may receive digital video data DATA and a data timing control signal DCS from the timing control circuit 400. The data driver 700 converts the digital video data DATA into analog data voltages according to the data timing control signal DCS and outputs the analog data voltages to data lines DL. In this case, the sub-pixels SP1, SP2, and SP3 may be selected by the write scan signal of the scan driver 610, and data voltages may be supplied to the selected sub-pixels SP1, SP2, and SP3.

The heat dissipation layer 200 may overlap the display panel 100 in a third direction DR3, which is a thickness direction of the display panel 100. The heat dissipation layer 200 may be located on one surface, e.g., the rear surface, of the display panel 100. The heat dissipation layer 200 serves to dissipate heat generated from the display panel 100. The heat dissipation layer 200 may include a metal layer having high thermal conductivity, such as graphite, silver (Ag), copper (Cu), or aluminum (Al).

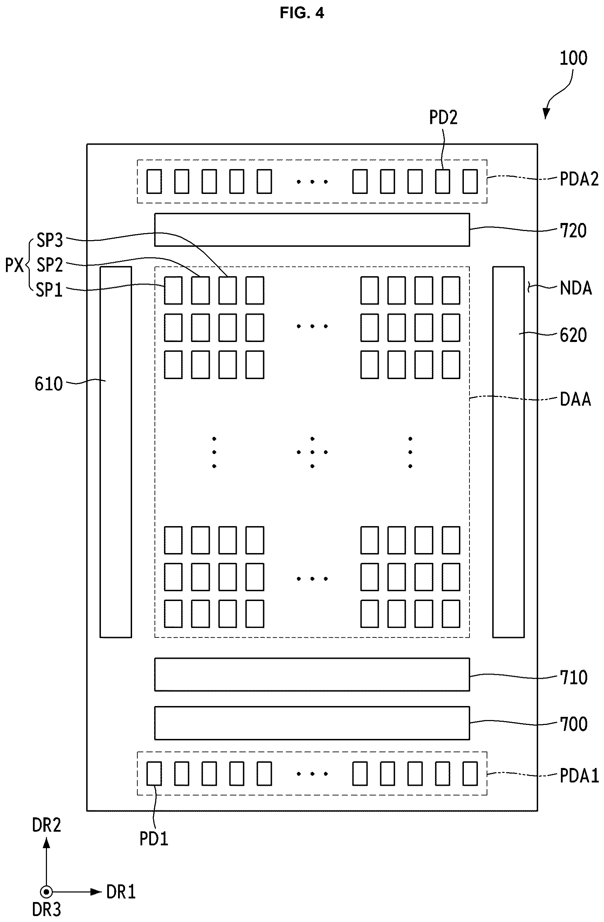

The circuit board 300 may be electrically connected to a plurality of first pads PD1 (see FIG. 4) of a first pad portion PDA1 (see FIG. 4) of the display panel 100 by using a conductive adhesive member such as an anisotropic conductive film. The circuit board 300 may be a flexible printed circuit board with a flexible material, or a flexible film. Although the circuit board 300 is illustrated in FIG. 1 as being unfolded, the circuit board 300 may be bent. In this case, one end of the circuit board 300 may be located on the rear surface of the display panel 100 and/or the rear surface of the heat dissipation layer 200. The other end of the circuit board 300 may be connected to the plurality of first pads PD1 (see FIG. 4) of the first pad portion PDA1 (see FIG. 4) of the display panel 100 by using a conductive adhesive member. One end of the circuit board 300 may be an opposite end of the other end of the circuit board 300.

The timing control circuit 400 may receive digital video data and timing signals inputted from the outside. The timing control circuit 400 may generate the scan timing control signal SCS, the emission timing control signal ECS, and the data timing control signal DCS for controlling the display panel 100 in response to the timing signals. The timing control circuit 400 may output the scan timing control signal SCS to the scan driver 610, and output the emission timing control signal ECS to the emission driver 620. The timing control circuit 400 may output the digital video data and the data timing control signal DCS to the data driver 700.

The power supply circuit 500 may generate a plurality of panel driving voltages according to a power voltage from the outside. For example, the power supply circuit 500 may generate a first driving voltage VSS, a second driving voltage VDD, and a third driving voltage VINT and supply them to the display panel 100. The first driving voltage VSS, the second driving voltage VDD, and the third driving voltage VINT will be described later in conjunction with FIG. 3.

Each of the timing control circuit 400 and the power supply circuit 500 may be formed as an integrated circuit (IC) and attached to one surface of the circuit board 300. In this case, the scan timing control signal SCS, the emission timing control signal ECS, the digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

Alternatively, each of the timing control circuit 400 and the power supply circuit 500 may be located in the non-display area NDA of the display panel 100, similarly to the scan driver 610, the emission driver 620, and the data driver 700. In this case, the timing control circuit 400 may include a plurality of timing transistors, and each power supply circuit 500 may include a plurality of power transistors. The plurality of timing transistors and the plurality of power transistors may be formed on the semiconductor substrate SSUB (see FIG. 7) through a semiconductor process. For example, the plurality of timing transistors and the plurality of power transistors may be formed as CMOS transistors, but the embodiment of the present disclosure is not limited thereto. Each of the timing control circuit 400 and the power supply circuit 500 may be located between the data driver 700 and the first pad portion PDA1 (see FIG. 4).

The first lens 777 may be located on the display panel 100. For example, the first lens 777 may be located on the display panel 100 so as to overlap the display area DAA of the display panel 100. The first lens 777 may overlap the entire display area DAA. For example, in a plan view, the first lens 777 may surround the edge of the display area DAA. The first lens 777 may have a hemispherical shape. The first lens may include, for example, a pancake lens.

FIG. 3 is an equivalent circuit diagram of a first sub-pixel according to one embodiment.

Referring to FIG. 3, a first sub-pixel SP1 may be connected to the write scan line GWL, the control scan line GCL, the bias scan line GBL, the first emission control line ECL1, the second emission control line EL2, and the data line DL. Further, the first sub-pixel SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied.

The first sub-pixel SP1 includes a plurality of transistors TR1 to TR6, a light emitting element LE, a first capacitor CP1, and a second capacitor CP2.

The light emitting element LE emits light in response to a driving current flowing through the channel of the first transistor TR1. A light emission amount of the light emitting element LE may be proportional to the driving current. The first electrode of the light emitting element LE may be an anode electrode, and the second electrode of the light emitting element LE may be a cathode electrode. The light emitting element LE may be an organic light emitting diode including a first electrode, a second electrode, and an organic light emitting layer located between the first electrode and the second electrode, but the embodiment of the present disclosure is not limited thereto. For example, the light emitting element LE may be an inorganic light emitting element including a first electrode, a second electrode, and an inorganic semiconductor located between the first electrode and the second electrode, in which case the light emitting element LE may be a micro light emitting diode.

The first transistor TR1 may be a driving transistor that controls a source-drain current Ids (hereinafter referred to as "driving current") flowing between the source electrode and the drain electrode according to a voltage applied to the gate electrode.

A second transistor TR2 may be located between one electrode of the first capacitor CP1 and the data line DL. The second transistor TR2 is turned on by the write scan signal of the write scan line GWL to connect the one electrode of the first capacitor CP1 to the data line DL. Accordingly, the data voltage of the data line DL may be applied to the one electrode of the first capacitor CP1.

A third transistor TR3 may be located between a first node ND1 and a second node ND2. The third transistor TR3 is turned on by the write control signal of the write control line GCL to connect the first node ND1 to the second node ND2. For this reason, when the gate electrode and the source electrode of the first transistor TR1 are connected, the first transistor TR1 may operate like a diode.

The fourth transistor TR4 may be connected between the second node ND2 and a third node ND3. The fourth transistor TR4 is turned on by the first emission control signal of the first emission control line ECL1 to connect the second node ND2 to the third node ND3. Accordingly, the driving current of the first transistor TR1 may be supplied to the light emitting element LE.

A fifth transistor TR5 may be located between the third node ND3 and the third driving voltage line VIL. The fifth transistor TR5 is turned on by the bias scan signal of the bias scan line GBL to connect the third node ND3 to the third driving voltage line VIL. Accordingly, the third driving voltage VINT of the third driving voltage line VIL may be applied to the first electrode of the light emitting element LE.

The sixth transistor TR6 may be located between the source electrode of the first transistor TR1 and the second driving voltage line VDL. The sixth transistor TR6 is turned on by the second emission control signal of the second emission control line EL2 to connect the source electrode of the first transistor TR1 to the second driving voltage line VDL. Accordingly, the second driving voltage VDD of the second driving voltage line VDL may be applied to the source electrode of the first transistor TR1.

The first capacitor CP1 is formed between the first node ND1 and the drain electrode of the second transistor TR2. The second capacitor CP2 is formed between the gate electrode of the first transistor TR1 and the second driving voltage line VDL.

Each of the first to sixth transistors TR1 to TR6 may be a metal-oxide-semiconductor field effect transistor (MOSFET). For example, each of the first to sixth transistors TR1 to TR6 may be a p-type MOSFET, but the embodiment of the present disclosure is not limited thereto. Each of the first to sixth transistors TR1 to TR6 may be an n-type MOSFET. Alternatively, some of the first to sixth transistors TR1 to TR6 may be p-type MOSFETs, and each of the remaining transistors may be an n-type MOSFET.

Although it is illustrated in FIG. 3 that the first sub-pixel SP1 includes six transistors TR1 to TR6 and two capacitors CP1 and CP2, the equivalent circuit diagram of the first sub-pixel SP1 is not limited to that shown in FIG. 3. For example, the number of transistors and the number of capacitors of the first sub-pixel SP1 are not limited to those shown in FIG. 3.

Further, the equivalent circuit diagram of the second sub-pixel SP2 and the equivalent circuit diagram of the third sub-pixel SP3 may be substantially the same as the equivalent circuit diagram of the first sub-pixel SP1 described in conjunction with FIG. 3. Therefore, the description of the equivalent circuit diagram of the second sub-pixel SP2 and the equivalent circuit diagram of the third sub-pixel SP3 is not repeated in the present disclosure.

FIG. 4 is a layout diagram illustrating an example of a display panel according to one embodiment.

Referring to FIG. 4, the display area DAA of the display panel 100 according to one embodiment includes the plurality of pixels PX arranged in a matrix form. The non-display area NDA of the display panel 100 according to one embodiment includes the scan driver 610, the emission driver 620, the data driver 700, a first distribution circuit 710, a second distribution circuit 720, the first pad portion PDA1, and a second pad portion PDA2.

The scan driver 610 may be located on a first side of the display area DAA, and the emission driver 620 may be located on a second side of the display area DAA. For example, the scan driver 610 may be located on one side of the display area DAA in the first direction DR1, and the emission driver 620 may be located on the other side of the display area DAA in the first direction DR1. However, the embodiment of the present disclosure is not limited thereto, and the scan driver 610 and the emission driver 620 may be located on both the first side and the second side of the display area DAA.

The first pad portion PDA1 may include the plurality of first pads PD1 connected to pads or bumps of the circuit board 300 through a conductive adhesive member. The first pad portion PDA1 may be located on a third side of the display area DAA. For example, the first pad portion PDA1 may be located on one side of the display area DAA in the second direction DR2. The first pad portion PDA1 may be located outside the data driver 700 in the second direction DR2.

The second pad portion PDA2 may include a plurality of second pads PD2 corresponding to inspection pads that test whether the display panel 100 operates normally. The plurality of second pads PD2 may be connected to a jig or a probe pin during an inspection process, or may be connected to a circuit board for inspection. The circuit board for inspection may be a printed circuit board including a rigid material or a flexible printed circuit board including a flexible material.

The second pad portion PDA2 may be located on a fourth side of the display area DAA. For example, the second pad portion PDA2 may be located on the other side of the display area DAA in the second direction DR2. The second pad portion PDA2 may be located outside the second distribution circuit 720 in the second direction DR2.

The first distribution circuit 710 distributes data voltages applied through the first pad portion PDA1 to the plurality of data lines DL. For example, the first distribution circuit 710 may distribute the data voltages applied through one first pad PD1 of the first pad portion PDA1 to the P (P is a positive integer of 2 or more) data lines DL, and as a result, the number of the plurality of first pads PD1 may be reduced. The first distribution circuit 710 may be located on the third side of the display area DAA of the display panel 100. For example, the first distribution circuit 710 may be located on one side of the display area DAA in the second direction DR2.

The second distribution circuit 720 distributes signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be located on the fourth side of the display area DAA of the display panel 100. For example, the second distribution circuit 720 may be located on the other side of the display area DAA in the second direction DR2.

A cathode connection portion CCA may be a region in which a second electrode CAT (see FIG. 7) of a display element layer EML (see FIG. 7) is connected to the first driving voltage line VSL of the non-display area NDA. The cathode connection portion CCA may be located outside at least one side of the display area DAA. For example, the cathode connection portion CCA may be located outside at least on one side among the left side, the right side, the upper side, and the lower side of the display area DAA. Alternatively, the cathode connection portion CCA may be located to surround the display area DAA as shown in FIG. 4 in order to minimize a deviation in the first driving voltage VSS due to a voltage drop (IR drop) or voltage rise (IR rising) of the second electrode CAT in the display area DAA.

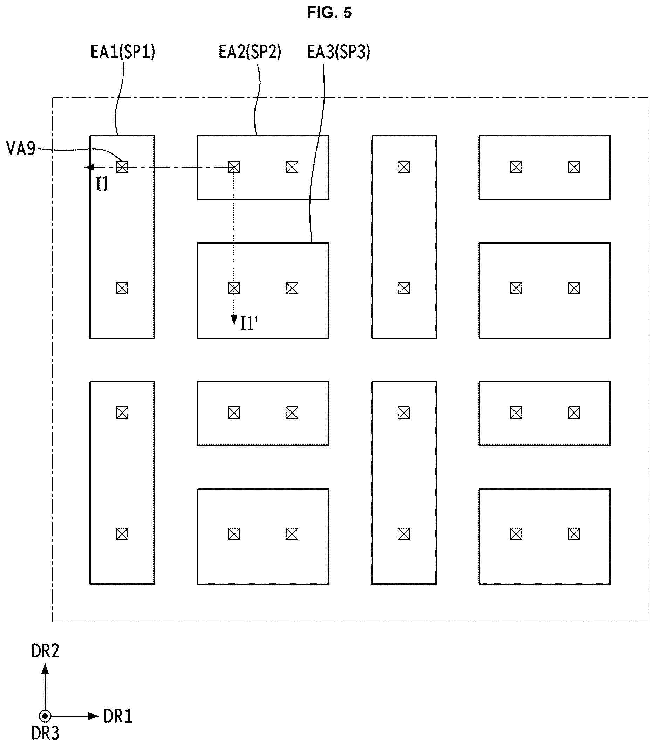

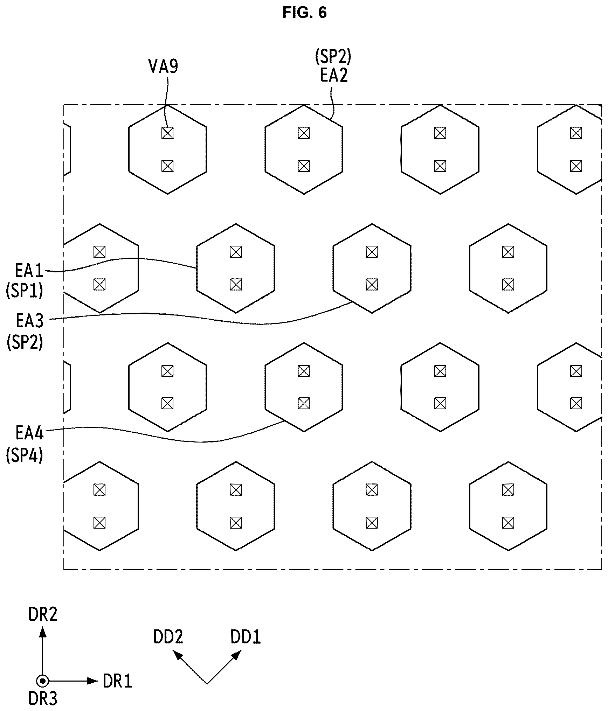

FIG. 5 is a layout diagram showing an example of the display area of FIG. 4. FIG. 6 is a layout diagram showing another example of the display area of FIG. 4.

Referring to FIGS. 5 and 6, each of the pixels PX includes a first emission area EA1 that is an emission area of the first sub-pixel SP1, a second emission area EA2 that is an emission area of the second sub-pixel SP2, and a third emission area EA3 that is an emission area of the third sub-pixel SP3.

The first emission area EA1, the second emission area EA2, and the third emission area EA3 may have, in a plan view, a quadrilateral or hexagonal shape as shown in FIGS. 5 and 6, but the present disclosure is not limited thereto. The first emission area EA1, the second emission area EA2, and the third emission area EA3 may have a polygonal shape other than a quadrangle or hexagon, a circular shape, an elliptical shape, or an atypical shape in a plan view.

As shown in FIG. 5, in each of the plurality of pixels PX, the first emission area EA1 and the second emission area EA2 may be adjacent to each other in the first direction DR1. Further, the first emission area EA1 and the third emission area EA3 may be adjacent to each other in the first direction DR1. In addition, the second emission area EA2 and the third emission area EA3 may be adjacent to each other in the second direction DR2. The area of the first emission area EA1, the area of the second emission area EA2, and the area of the third emission area EA3 may be different.

Alternatively, as shown in FIG. 6, the emission areas EA1, EA2, EA3, and EA4 may have a hexagonal shape in a plan view. In this case, the first emission area EA1 and the third emission area EA3 may be adjacent in the first direction DR1, and the second emission area EA2 and the fourth emission area EA4 may be adjacent in the second direction DR2. Additionally, the first emission area EA1 and the second emission area EA2 may be adjacent in a first diagonal direction DD1, and the second emission area EA2 and the third emission area EA3 may be adjacent in a second diagonal direction DD2. Additionally, the first emission area EA1 and the fourth emission area EA4 may be adjacent in the second diagonal direction DD2, and the third emission area EA3 and the fourth emission area EA4 may be adjacent in the first diagonal direction DD1. The first diagonal direction DD1 may be a direction between the first direction DR1 and the second direction DR2, and may refer to a direction inclined by 45 degrees with respect to the first direction DR1 and the second direction DR2, and the second diagonal direction DD2 may be a direction perpendicular to the first diagonal direction DD1.

The first sub-pixel SP1 may emit first light, the second sub-pixel SP2 may emit second light, and the third sub-pixel SP3 may emit third light. Here, the first light may be light of a blue wavelength band, the second light may be light of a green wavelength band, and the third light may be light of a red wavelength band. For example, the blue wavelength band may be a wavelength band of light whose main peak wavelength is in the range of approximately 370 nm to 460 nm, the green wavelength band may be a wavelength band of light whose main peak wavelength is in the range of approximately 480 nm to 560 nm, and the red wavelength band may be a wavelength band of light whose main peak wavelength is in the range of approximately 600 nm to 750 nm.

Each of the plurality of pixels PX may include three emission areas EA1, EA2, and EA3 as shown in FIG. 5, or may include four emission areas EA1, EA2, EA3, and EA4 as shown in FIG. 6. In this case, the fourth emission area EA4 may emit the same second light as the second emission area EA2, but the present disclosure is not limited thereto.

The emission areas of the plurality of pixels PX may be arranged in a stripe structure in which the emission areas are arranged in the first direction DR1, a PenTile^{®} structure in which the emission areas EA1, EA2, EA3, and EA4 are arranged in a rhombus shape, or a hexagonal structure in which the emission areas each having a hexagonal shape are arranged as shown in FIG. 6.

FIG. 7 is a cross-sectional view illustrating an example of a display panel taken along line I1-I1' of FIG. 5.

Referring to FIG. 7, the display panel 100 includes a semiconductor backplane SBP, a light emitting element backplane EBP, the display element layer EML, an encapsulation layer TFE, an optical layer OPL, a cover layer CV, and a polarizing plate POL.

The semiconductor backplane SBP includes the semiconductor substrate SSUB including a plurality of pixel transistors PTR, a plurality of semiconductor insulating layers covering the plurality of pixel transistors PTR, and a plurality of contact terminals CTE electrically connected to the plurality of pixel transistors PTR, respectively. The plurality of pixel transistors PTR may be the first to sixth transistors TR1 to TR6 described with reference to FIG. 3.

The semiconductor substrate SSUB may be a silicon substrate, a germanium substrate, or a silicon-germanium substrate. The semiconductor substrate SSUB may be a substrate doped with a first type impurity. A plurality of well regions WA may be located on the top surface of the semiconductor substrate SSUB. The plurality of well regions WA may be regions doped with a second type impurity. The second type impurity may be different from the first type impurity. For example, when the first type impurity is a p-type impurity, the second type impurity may be an n-type impurity. Alternatively, when the first type impurity is an n-type impurity, the second type impurity may be a p-type impurity.

Each of the plurality of well regions WA includes a source region SA corresponding to the source electrode of the pixel transistor PTR, a drain region DA corresponding to the drain electrode, and a channel region CH located between the source region SA and the drain region DA.

A lower insulating layer BINS may be located between a gate electrode GE and the well region WA. A side insulating layer SINS may be located on the side surface of the gate electrode GE. The side insulating layer SINS may be located on the lower insulating layer BINS.

Each of the source region SA and the drain region DA may be a region doped with the first type impurity. The gate electrode GE of the pixel transistor PTR may overlap the well region WA in the third direction DR3, which is the thickness direction of the semiconductor substrate SSUB. The channel region CH may overlap the gate electrode GE in the third direction DR3. The source region SA may be located on one side of the gate electrode GE, and the drain region DA may be located on the other side of the gate electrode GE.

Each of the plurality of well regions WA further includes a first low-concentration impurity region LDD1 located between the channel region CH and the source region SA, and a second low-concentration impurity region LDD2 located between the channel region CH and the drain region DA. The first low-concentration impurity region LDD1 may be a region having a lower impurity concentration than the source region SA due to the lower insulating layer BINS. The second low-concentration impurity region LDD2 may be a region having a lower impurity concentration than the drain region DA due to the lower insulating layer BINS. The distance between the source region SA and the drain region DA may increase due to the first low-concentration impurity region LDD1 and the second low-concentration impurity region LDD2, which may result in an increase of the length of the channel region CH of each of the pixel transistors PTR.

A first semiconductor insulating layer SINS1 may be located on the semiconductor substrate SSUB. A second semiconductor insulating layer SINS2 may be located on the first semiconductor insulating layer SINS1.

The plurality of contact terminals CTE may be located on the second semiconductor insulating layer SINS2. Each of the plurality of contact terminals CTE may be connected to any one of the gate electrode GE, the source region SA, and the drain region DA of each of the pixel transistors PTR through holes penetrating the first semiconductor insulating layer SINS1 and the second semiconductor insulating layer SINS2. The plurality of contact terminals CTE may include any one of copper (Cu), aluminum (Al), tungsten (W), molybdenum (Mo), chromium (Cr), gold (Au), titanium (Ti), nickel (Ni), and neodymium (Nd), or an alloy including any one of them.

A third semiconductor insulating layer SINS3 may be located on a side surface of each of the plurality of contact terminals CTE. The top surface of each of the plurality of contact terminals CTE may be exposed without being covered by the third semiconductor insulating layer SINS3.

Each of the first semiconductor insulating layer SINS1, the second semiconductor insulating layer SINS2, and the third semiconductor insulating layer SINS3 may include silicon carbonitride (SiCN) or a silicon oxide (SiOₓ)-based inorganic layer, but the present disclosure is not limited thereto.

The semiconductor substrate SSUB may be replaced with a glass substrate or a polymer resin substrate such as polyimide. In this case, thin film transistors may be located on the glass substrate or the polymer resin substrate. The glass substrate may be a rigid substrate that does not bend, and the polymer resin substrate may be a flexible substrate that can be bent or curved.

The light emitting element backplane EBP includes a plurality of conductive layers ML1 to ML8, a plurality of vias VA1 to VA9, and a plurality of insulating layers INS1 to INS11. In addition, the light emitting element backplane EBP includes a plurality of insulating layers INS1 to INS9 located between the first to eighth conductive layers ML1 to ML8.

First to eighth insulating layers INS1 to INS8 serve to insulate the first to eighth conductive layers ML1 to ML8. The first to eighth conductive layers ML1 to ML8 serve to connect the plurality of contact terminals CTE exposed from the semiconductor backplane SBP to thereby implement the circuit of the first sub-pixel SP1 shown in FIG. 3.

For example, the first to sixth transistors TR1 to TR6 are merely formed in the semiconductor backplane SBP, and the connection of the first to sixth transistors TR1 to TR6 and the first and second capacitors CP1 and CP2 is accomplished through the first to eighth conductive layers ML1 to ML8. In addition, the connection between the drain region corresponding to the drain electrode of the fourth transistor TR4, the source region corresponding to the source electrode of the fifth transistor TR5, and a first electrode AND of the light emitting element LE is also accomplished through the first to eighth conductive layers ML1 to ML8.

The first to eighth conductive layers ML1 to ML8 and the first to eighth vias VA1 to VA8 may include substantially the same material. The first to eighth conductive layers ML1 to ML8 and the first to eighth vias VA1 to VA8 may include any one of copper (Cu), aluminum (Al), tungsten (W), molybdenum (Mo), chromium (Cr), gold (Au), titanium (Ti), nickel (Ni), and neodymium (Nd), or an alloy including any one of them. The first to eighth vias VA1 to VA8 may include substantially the same material. First to eighth insulating layers INS1 to INS8 may be formed as silicon oxide (SiOₓ)-based inorganic layers, but the embodiment of the present disclosure is not limited thereto.

A ninth insulating layer INS9 may be located on the eighth insulating layer INS8 and the eighth conductive layer ML8. The ninth insulating layer INS9 may be formed as a silicon oxide (SiOₓ)-based inorganic layer, but the embodiment of the present disclosure is not limited thereto.

Each of ninth vias VA9 may penetrate the ninth insulating layer INS9 and be connected to the exposed eighth conductive layer ML8. The ninth vias VA9 may include any one of copper (Cu), aluminum (Al), tungsten (W), molybdenum (Mo), chromium (Cr), gold (Au), titanium (Ti), nickel (Ni), and neodymium (Nd), or an alloy including any one of them.

The display element layer EML may be located on the light emitting element backplane EBP. The display element layer EML may include tenth and eleventh insulating layers INS10 and INS11, a reflective electrode RL, the first electrodes AND, a light emitting stack IL, the second electrode CAT, a pixel defining layer PDL, and a plurality of trenches TRC.

The reflective electrode RL may be located on the ninth insulating layer INS9. The reflective electrode RL may include at least one reflective electrode RL1, RL2, RL3, and RL4. For example, the reflective electrode RL may include first to fourth reflective electrodes RL1, RL2, RL3, and RL4 as shown in FIG. 7.

The first reflective electrodes RL1 may be located on the ninth interlayer-insulating layer INS9, and may be connected to the ninth via VA9. Each of the second reflective electrodes RL2 may be located on the first reflective electrode RL1 corresponding thereto. Each of the third reflective electrodes RL3 may be located on the second reflective electrode RL2 corresponding thereto. Each of the fourth reflective electrodes RL4 may be located on the third reflective electrode RL3 corresponding thereto.

Since the second reflective electrode RL2 is an electrode that substantially reflects light from the light emitting elements LE, the thickness of the second reflective electrode RL2 may be greater than the thickness of each of the first reflective electrode RL1, the third reflective electrode RL3, and the fourth reflective electrode RL4.

The first reflective electrodes RL1 may include any one of copper (Cu), aluminum (Al), tungsten (W), molybdenum (Mo), chromium (Cr), gold (Au), titanium (Ti), nickel (Ni), and neodymium (Nd), or an alloy including any one of them. For example, the first reflective electrodes RL1 may include titanium nitride (TiN), the second reflective electrodes RL2 may include aluminum (Al), the third reflective electrodes RL3 may include titanium nitride (TiN), and the fourth reflective electrodes RL4 may include titanium (Ti).

The tenth interlayer-insulating layer INS10 may be located on the ninth interlayer-insulating layer INS9. The tenth interlayer-insulating layer INS10 may be located between the reflective electrodes RL adjacent to each other. The tenth interlayer-insulating layer INS10 may be a film for flattening a stepped portion caused by the reflective electrodes RL. The eleventh interlayer-insulating layer INS11 may be located on the tenth interlayer-insulating layer INS10 and the reflective electrode RL.

The tenth interlayer-insulating layer INS10 and the eleventh interlayer-insulating layer INS11 may be formed as silicon oxide (SiOₓ)-based inorganic layers, but the embodiment of the present disclosure is not limited thereto.

The eleventh interlayer-insulating layer INS11 may be an optical auxiliary layer for adjusting the resonance distance of light emitted from the light emitting stack IL in at least one of the first sub-pixel SP1, the second sub-pixel SP2, or the third sub-pixel SP3. The thickness of the eleventh interlayer-insulating layer INS11 may be different in the first sub-pixel SP1, the second sub-pixel SP2, and the third sub-pixel SP3. That is, in order to adjust a distance from the reflective electrode RL to the second electrode CAT according to a main wavelength of light emitted from each of the first sub-pixel SP1, the second sub-pixel SP2, and the third sub-pixel SP3, the thickness of the eleventh interlayer-insulating layer INS11 may be set for each of the first sub-pixel SP1, the second sub-pixel SP2, and the third sub-pixel SP3.

For example, as shown in FIG. 7, the thickness of the eleventh interlayer-insulating layer INS11 in the first sub-pixel SP1 may be greater than the thickness of the eleventh interlayer-insulating layer INS11 in the second sub-pixel SP2, and the thickness of the eleventh interlayer-insulating layer INS11 in the second sub-pixel SP2 may be greater than the thickness of the eleventh interlayer-insulating layer INS11 in the third sub-pixel SP3. In this case, the distance between the first electrode AND and the reflective electrode RL in the first sub-pixel SP1 is greater than the distance between the first electrode AND and the reflective electrode RL in the second sub-pixel SP2. In addition, the distance between the first electrode AND and the reflective electrode RL in the second sub-pixel SP2 is greater than the distance between the first electrode AND and the reflective electrode RL in the third sub-pixel SP3.

Each of the tenth vias VA10 may penetrate the eleventh interlayer-insulating layer INS11 and be connected to the exposed ninth metal layer ML9. The tenth vias VA10 may include any one of copper (Cu), aluminum (Al), tungsten (W), molybdenum (Mo), chromium (Cr), gold (Au), titanium (Ti), nickel (Ni), and neodymium (Nd), or an alloy including any one of them. The thickness of the tenth via VA10 in the first sub-pixel SP1 may be greater than the thickness of the tenth via VA10 in the second sub-pixel SP2, and the thickness of the tenth via VA10 in the second sub-pixel SP2 may be greater than the thickness of the tenth via VA10 in the third sub-pixel SP3.

The first electrode AND of each of the light emitting elements LE may be located on the eleventh interlayer-insulating layer INS11 and connected to the tenth via VA10. The first electrode AND of each of the light emitting elements LE may be connected to the drain region DA or source region SA of the pixel transistor PTR through the tenth via VA10, the reflective electrode RL, the first to ninth vias VA1 to VA9, the first to eighth metal layers ML1 to ML8, and the contact terminal CTE. The first electrode AND of each of the light emitting elements LE may include any one of copper (Cu), aluminum (Al), tungsten (W), molybdenum (Mo), chromium (Cr), gold (Au), titanium (Ti), nickel (Ni), and neodymium (Nd), or an alloy including any one of them. For example, the first electrode AND of each of the light emitting elements LE may be titanium nitride (TiN).

The pixel defining layer PDL may be located on a part of the first electrode AND of each of the light emitting elements LE. The pixel defining layer PDL may cover the edge of the first electrode AND of each of the light emitting elements LE. The pixel defining layer PDL may partition the first emission areas EA1, the second emission areas EA2, and the third emission areas EA3. Each of the first emission area EA1, the second emission area EA2, and the third emission area EA3 may be an area where the light emitting element LE including the first electrode AND, the light emitting stack IL, and the second electrode CAT is located.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The pixel defining layer PDL may include first to third pixel defining layers PDL1, PDL2, and PDL3. The first pixel defining layer PDL1 may be located on the edge of the first electrode AND of each of the light emitting elements LE, the second pixel defining layer PDL2 may be located on the first pixel defining layer PDL1, and the third pixel defining layer PDL3 may be located on the second pixel defining layer PDL2. The first pixel defining layer PDL1, the second pixel defining layer PDL2, and the third pixel defining layer PDL3 may be formed as silicon oxide (SiOₓ)-based inorganic layers. Alternatively, the first pixel defining layer PDL1 and the third pixel defining layer PDL3 may be formed as silicon nitride (SiNₓ)-based inorganic layers, whereas the second pixel defining layer PDL2 may be formed as a silicon oxide (SiOₓ)-based inorganic layer. The first pixel defining layer PDL1, the second pixel defining layer PDL2, and the third pixel defining layerPDL3 may each have a thickness of about 500 Å.

In order to reduce or prevent the likelihood of the first encapsulation inorganic layer TFE1 being cut off due to the step coverage, the first pixel defining layer PDL1, the second pixel defining layer PDL2, and the third pixel defining layer PDL3 may have a cross-sectional structure having a stepped portion. Step coverage refers to the ratio of the degree of thin film coated on an inclined portion to the degree of thin film coated on a flat portion. The lower the step coverage, the more likely it is that the thin film will be cut off at inclined portions.

Each of the plurality of trenches TRC may penetrate the first pixel defining layer PDL1, the second pixel defining layer PDL2, and the third pixel defining layer PDL3. The eleventh interlayer-insulating layer INS11 may be at least partially recessed at each of the plurality of trenches TRC.

At least one trench TRC may be located between the neighboring sub-pixels SP1, SP2, and SP3. Although FIG. 7 illustrates that two trenches TRC are located between the neighboring sub-pixels SP1, SP2, and SP3, the present disclosure is not limited thereto.

The light emitting stack IL may include a plurality of stack layers IL1, IL2, and IL3. FIG. 7 illustrates that the light emitting stack IL has a three-tandem structure including a first stack layer IL1, a second stack layer IL2, and a third stack layer IL3, but the present disclosure is not limited thereto. For example, the light emitting stack IL may have a two-tandem structure including two stack layers.

In the three-tandem structure, the light emitting stack IL may have a tandem structure including a plurality of intermediate layers IL1, IL2, and IL3 that emit different lights. For example, the light emitting stack IL may include the first stack layer IL1 that emits the first light, the second stack layer IL2 that emits the second light, and the third stack layer IL3 that emits the third light. The first stack layer IL1, the second stack layer IL2, and the third stack layer IL3 may be sequentially stacked.

The first stack layer IL1 may have a structure in which a first hole transport layer, a first light emitting layer that emits the first light, and a first electron transport layer are sequentially stacked. The second stack layer IL2 may have a structure in which a second hole transport layer, a second light emitting layer that emits the second light, and a second electron transport layer are sequentially stacked. The third stack layer IL3 may have a structure in which a third hole transport layer, a third light emitting layer that emits the third light, and a third electron transport layer are sequentially stacked.

A first charge generation layer for supplying charges to the second stack layer IL2 and supplying electrons to the first stack layer IL1 may be located between the first stack layer IL1 and the second stack layer IL2. The first charge generation layer may include an N-type charge generation layer that supplies electrons to the first stack layer IL1 and a P-type charge generation layer that supplies holes to the second stack layer IL2. The N-type charge generation layer may include a dopant of a metal material.

A second charge generation layer for supplying charges to the third stack layer IL3 and supplying electrons to the second stack layer IL2 may be located between the second stack layer IL2 and the third stack layer IL3. The second charge generation layer may include an N-type charge generation layer that supplies electrons to the second stack layer IL2 and a P-type charge generation layer that supplies holes to the third stack layer IL3.

The first stack layer IL1 may be located on the first electrodes AND and the pixel defining layer PDL, and a residual film RIL located on the bottom surface of each trench TRC may be the same material as the first stack layer IL1. Due to the trench TRC, the first stack layer IL1 may be cut off between the neighboring sub-pixels SP1, SP2, and SP3. The second stack layer IL2 may be located on the first stack layer IL1. Due to the trench TRC, the second stack layer IL2 may be cut off between the neighboring sub-pixels SP1, SP2, and SP3. A cavity ESS or an empty space may be located between the residual film RIL and the second stack layer IL2 in the trench TRC. The third stack layer IL3 may be located on the second stack layer IL2. The third stack layer IL3 is not cut off by the trench TRC and may be located to cover the second stack layer IL2 in each of the trenches TRC.

In the three-tandem structure, each of the plurality of trenches TRC may be a structure for cutting off the first to third hole transport layers, the first charge generation layer, and the second charge generation layer of the first to third stack layers IL1, IL2, and IL3 of the display element layer EML between the neighboring sub-pixels SP1, SP2, and SP3. In addition, in the two-tandem structure, each of the plurality of trenches TRC may be a structure for cutting off the charge generation layer and the lower stack layer located between the lower stack layer and the upper stack layer.

In order to stably cut off the first and second stack layers IL1 and IL2 of the display element layer EML between the neighboring sub-pixels SP1, SP2, and SP3, the height of each of the plurality of trenches TRC may be greater than the height of the pixel defining layer PDL. The height of each of the plurality of trenches TRC refers to the length of each of the plurality of trenches TRC in the third direction DR3. The height of the pixel defining layer PDL refers to the length of the pixel defining layer PDL in the third direction DR3. In order to cut off the charge generation layers and the hole transport layers of the light emitting stack IL of the display element layer EML between the neighboring sub-pixels SP1, SP2, and SP3, another structure may exist instead of the trench TRC. For example, instead of the trench TRC, a reverse tapered partition wall may be located on the pixel defining layer PDL.

In addition, FIG. 7 illustrates that the light emitting stack IL that emits light is located in the first emission area EA1, the second emission area EA2, and the third emission area EA3, but the present disclosure is not limited thereto. For example, instead of the light emitting stack IL, the first light emitting layer may be located in the first emission area EA1, and may be omitted from the second emission area EA2 and the third emission area EA3. Furthermore, the second light emitting layer may be located in the second emission area EA2 and may be omitted from the first emission area EA1 and the third emission area EA3. Furthermore, the third light emitting layer may be located in the third emission area EA3 and may be omitted from the first emission area EA1 and the second emission area EA2. In this case, first to third color filters CF1, CF2, and CF3 of the optical layer OPL may be omitted.

The second electrode CAT may be located on the light emitting stack IL. The second electrode CAT may be located on the third stack layer IL3 in each of the plurality of trenches TRC. The second electrode CAT may include a transparent conductive material (TCO) such as ITO or IZO that can transmit light or a semi-transmissive conductive material such as magnesium (Mg), silver (Ag), or an alloy of Mg and Ag. When the second electrode CAT includes a semi-transmissive conductive material, the light output efficiency may be improved in each of the first to third sub-pixels SP1, SP2, and SP3 due to a micro-cavity effect.

The encapsulation layer TFE may be located on the display element layer EML. The encapsulation layer TFE may include at least one inorganic layer TFE1 and TFE2 to reduce or prevent oxygen or moisture from permeating into the display element layer EML. The first encapsulation inorganic layer TFE1 may be located on the second electrode CAT, and the second encapsulation inorganic layer TFE2 may be located on the first encapsulation inorganic layer TFE1. The first encapsulation inorganic layer TFE1 and the second encapsulation inorganic layer TFE3 may be formed as multiple films in which one or more inorganic layers of silicon nitride (SiNₓ), silicon oxynitride (SiON), silicon oxide (SiOₓ), titanium oxide (TiOₓ), and aluminum oxide (AlOₓ) layers are alternately stacked.

In addition, the encapsulation layer TFE may include at least one organic layer to protect the display element layer EML from foreign substances such as dust. The at least one organic layer of the encapsulation layer TFE may be located between the first encapsulation inorganic layer TFE1 and the second encapsulation inorganic layer TFE2. The at least one organic layer of the encapsulation layer TFE may be a monomer. Alternatively, at least one organic layer of the encapsulation layer TFE may be an organic layer such as acryl resin, epoxy resin, phenolic resin, polyamide resin, polyimide resin or the like.

An adhesive layer ADL may be a layer for bonding the encapsulation layer TFE to the optical layer OPL. The adhesive layer ADL may be a double-sided adhesive member. In addition, the adhesive layer ADL may be a transparent adhesive member such as a transparent adhesive or a transparent adhesive resin.

The optical layer OPL may include a plurality of color filters CF1, CF2, and CF3, a plurality of second lenses LNS, and an overcoat layer OC. The plurality of color filters CF1, CF2, and CF3 may include the first to third color filters CF1, CF2, and CF3. The first to third color filters CF1, CF2, and CF3 may be located on the adhesive layer ADL.

The first color filter CF1 may overlap the first emission area EA1 of the first sub-pixel SP1. The first color filter CF1 may transmit light of the first color, i.e., light of a blue wavelength band. The blue wavelength band may be about 370 nm to about 460 nm. Thus, the first color filter CF1 may transmit light of the first color among light emitted from the first emission area EA1.

The second color filter CF2 may overlap the second emission area EA2 of the second sub-pixel SP2. The second color filter CF2 may transmit light of the second color, i.e., light of a green wavelength band. The green wavelength band may be about 480 nm to about 560 nm. Thus, the second color filter CF2 may transmit light of the second color among light emitted from the second emission area EA2.

The third color filter CF3 may overlap the third emission area EA3 of the third sub-pixel SP3. The third color filter CF3 may transmit light of the third color, i.e., light of a red wavelength band. The red wavelength band may be about 600 nm to about 750 nm. Thus, the third color filter CF3 may transmit light of the third color among light emitted from the third emission area EA3.

The plurality of second lenses LNS may be located on the first color filter CF1, the second color filter CF2, and the third color filter CF3, respectively. Each of the plurality of second lenses LNS may be a structure for increasing the proportion of light directed to the front of the display device 10. Each of the plurality of second lenses LNS may have a cross-sectional shape that is convex in an upward direction. Each of the plurality of second lenses LNS may include a micro-lens.

The overcoat layer OC may be located on the plurality of second lenses LNS. The overcoat layer OC may have a selected refractive index such that light travels in the third direction DR3 at an interface between the overcoat layer OC and the plurality of second lenses LNS. Further, the overcoat layer OC may be a planarization layer. The overcoat layer OC may be an organic layer such as acryl resin, epoxy resin, phenolic resin, polyamide resin, polyimide resin and the like.

The cover layer CV may be located on the overcoat layer OC. The cover layer CV may be a glass substrate or a polymer resin. When the cover layer CV is a glass substrate, it may be attached onto the overcoat layer OC. In this case, the overcoat layer OC may serve to bond the cover layer CV. When the cover layer CV is a glass substrate, it may serve as an encapsulation substrate. When the cover layer CV is a polymer resin, it may be directly applied onto the overcoat layer OC.

The polarizing plate POL may be located on one surface of the cover layer CV. The polarizing plate POL may be a structure for reducing or preventing visibility degradation caused by reflection of external light. The polarizing plate POL may include a linear polarizing plate and a phase retardation film. For example, the phase retardation film may be a λ/4 plate (quarter-wave plate), but the embodiment of the present disclosure is not limited thereto. However, when visibility degradation caused by reflection of external light is sufficiently overcome by the first to third color filters CF1, CF2, and CF3, the polarizing plate POL may be omitted.

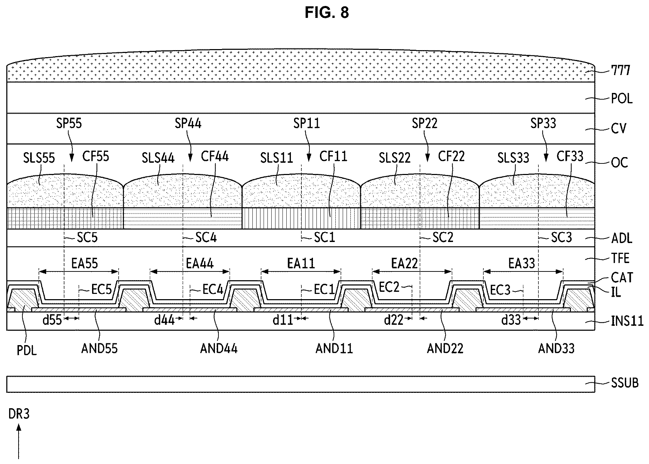

FIG. 8 is a cross-sectional view of a display device according to one embodiment.

The display device 10 of FIG. 8 is different from the display device 10 of FIG. 7 described above in the arrangement position of a color filter and a second lens with respect to an emission area in a sub-pixel, and the difference will be mainly described as follows.

As shown in FIG. 8, the first lens 777 may be located on the polarizing plate POL so as to overlap a plurality of second lenses SLS11, SLS22, SLS33, SLS44, and SLS55.

Five sub-pixels SP11, SP22, SP33, SP44, and SP55 are illustrated in FIG. 8. For example, the first sub-pixel SP11, the second sub-pixel SP22, the third sub-pixel SP33, the fourth sub-pixel SP44, and the fifth sub-pixel SP55 are illustrated in FIG. 8. Each of the sub-pixels SP11, SP22, SP33, SP44, and SP55 may include a first electrode (hereinafter, referred to as anode electrode), the light emitting stack IL, the second electrode CAT (hereinafter, referred to as cathode electrode CAT), a color filter, and a second lens (hereinafter, referred to as sub-lens).

The first sub-pixel SP11 may include a first emission area EA11, a first anode electrode AND11, the light emitting stack IL, the cathode electrode CAT, a first color filter CF11, and a first sub-lens SLS11. Here, the light emitting stack IL of the first sub-pixel SP11 may mean the light emitting stack IL between the first anode electrode AND11 and the cathode electrode CAT. The first color filter CF11 and the first sub-lens SLS11 may overlap each other.

The second sub-pixel SP22 may include a second emission area EA22, a second anode electrode AND22, the light emitting stack IL, the cathode electrode CAT, a second color filter CF22, and a second sub-lens SLS22. Here, the light emitting stack IL of the second sub-pixel SP22 may mean the light emitting stack IL between the second anode electrode AND22 and the cathode electrode CAT. The second color filter CF22 and the second sub-lens SLS22 may overlap each other.

The third sub-pixel SP33 may include a third emission area EA33, a third anode electrode AND33, the light emitting stack IL, the cathode electrode CAT, a third color filter CF33, and a third sub-lens SLS33. Here, the light emitting stack IL of the third sub-pixel SP33 may mean the light emitting stack IL between the third anode electrode AND33 and the cathode electrode CAT. The third color filter CF33 and the third sub-lens SLS33 may overlap each other.

The fourth sub-pixel SP44 may include a fourth emission area EA44, a fourth anode electrode AND44, the light emitting stack IL, the cathode electrode CAT, a fourth color filter CF44, and a fourth sub-lens SLS44. Here, the light emitting stack IL of the fourth sub-pixel SP44 may mean the light emitting stack IL between the fourth anode electrode AND44 and the cathode electrode CAT. The fourth color filter CF44 and the fourth sub-lens SLS44 may overlap each other.

The fifth sub-pixel SP55 may include a fifth emission area EA55, a fifth anode electrode AND55, the light emitting stack IL, the cathode electrode CAT, a fifth color filter CF55, and a fifth sub-lens SLS55. Here, the light emitting stack IL of the fifth sub-pixel SP55 may mean the light emitting stack IL between the fifth anode electrode AND55 and the cathode electrode CAT. The fifth color filter CF55 and the fifth sub-lens SLS55 may overlap each other.

The first sub-pixel SP11 may be located at the center of the display panel 100 (or the display area DAA of the display panel 100, or the first lens 777). For example, the first sub-pixel SP11 may overlap the center of the first lens 777. Specifically, the center of the first anode electrode AND11, the center of the first emission area EA11, the center of the first color filter CF11, and the center of the first lens 777 may overlap each other. Here, the first sub-pixel SP11 may be defined as a central sub-pixel.

The second to fifth sub-pixels SP22 to SP55 may be sequentially located on one side or the other side of the first sub-pixel SP11 with respect to the first sub-pixel SP11. For example, the second sub-pixel SP22 and the third sub-pixel SP33 may be sequentially located on one side of the first sub-pixel SP11, and the fourth sub-pixel SP44 and the fifth sub-pixel SP55 may be sequentially located on the other side of the first sub-pixel SP11. Here, the second to fifth sub-pixels SP22 to SP55 may be defined as peripheral sub-pixels.

When a color filter and a sub-lens included in one sub-pixel are defined as a sub-optical layer of the one sub-pixel, a center SC1 of a sub-optical layer of the central sub-pixel (e.g., the first sub-pixel SP11) located at the center of the display panel 100 (or at the center of the display area DAA, or at the center of the first lens 777) may overlap a center portion EC1 of the first emission area EA11 of the central sub-pixel (e.g., the first sub-pixel SP11).

In some embodiments, the center of a sub-optical layer of a peripheral sub-pixel does not overlap the center of an emission area of that peripheral sub-pixel. To this end, the sub-optical layer of the peripheral sub-pixel may be shifted by a selected distance toward the edge of the display panel 100 (or the display area DAA of the display panel 100, or the first lens 777) with respect to the center of the emission area of the peripheral sub-pixel. For example, the sub-optical layer (or a center SC2 of the sub-optical layer) of the second sub-pixel SP22 may be shifted by a selected distance toward the edge of the display panel 100 (or the display area DAA of the display panel 100, or the first lens 777) with respect to a center portion EC2 of the second emission area EA22; the sub-optical layer (or a center SC3 of the sub-optical layer) of the third sub-pixel SP33 may be shifted by a selected distance toward the edge of the display panel 100 (or the display area DAA of the display panel 100, or the first lens 777) with respect to a center portion EC3 of the third emission area EA33; the sub-optical layer (or a center SC4 of the sub-optical layer) of the fourth sub-pixel SP44 may be shifted by a selected distance toward the edge of the display panel 100 (or the display area DAA of the display panel 100, or the first lens 777) with respect to a center portion EC4 of the fourth emission area EA44; and the sub-optical layer (or a center SC5 of the sub-optical layer) of the fifth sub-pixel SP55 may be shifted by a selected distance toward the edge of the display panel 100 (or the display area DAA of the display panel 100, or the first lens 777) with respect to a center portion EC5 of the fifth emission area EA55.

The sub-optical layer of the peripheral sub-pixel may be shifted by a larger magnitude with an increase of its distance from the central sub-pixel. For example, between the second sub-pixel SP22 and the third sub-pixel SP33 sequentially located on one side of the first sub-pixel SP11, the third sub-pixel SP33 located relatively farther from the first sub-pixel SP11 may include a sub-optical layer shifted by a larger magnitude than the sub-optical layer of the second sub-pixel SP22. As another example, between the fourth sub-pixel SP44 and the fifth sub-pixel SP55 sequentially located on the other side of the first sub-pixel SP11, the fifth sub-pixel SP55 located relatively farther from the first sub-pixel SP11 may include a sub-optical layer shifted by a larger magnitude than that the sub-optical layer of the fourth sub-pixel SP44.

In other words, the sub-pixels SP11 to SP55 may include the sub-optical layers shifted by larger magnitudes as they are located farther from the center of the display panel 100 (or the display area DAA of the display panel 100, or the first lens 777). For example, when the distance between the center of the emission area of the sub-pixel and the center of the sub-optical layer of that sub-pixel is defined as a shift distance of that sub-pixel (or a shift distance of the sub-optical layer of that sub-pixel), a shift distance d11 of the first sub-pixel SP11 may be substantially zero; a shift distance d33 of the third sub-pixel SP33 may be greater than a shift distance d22 of the second sub-pixel SP22; and a shift distance d55 of the fifth sub-pixel SP55 may be greater than a shift distance d44 of the fourth sub-pixel SP44.

As the sub-pixels SP11 to SP55 include the sub-optical layers shifted by the larger magnitudes as they are located farther from the center of the display panel 100 (or the display area DAA of the display panel 100, or the first lens 777) as described above, light at the edge of the first lens 777 may be emitted to the outside while satisfying a chief ray angle (CRA).

The constituent components between the semiconductor substrate SSUB and the eleventh insulating layer INS11 of FIG. 7 may also be located between the substrate SSUB (e.g., the semiconductor substrate SSUB) and the eleventh insulating layer INS11 of FIG. 8.

Also, the pixel defining layer PDL of FIG. 8 may include the first pixel defining layer PDL1, the second pixel defining layer PDL2, and the third pixel defining layer PDL3 of FIG. 7.

In addition, the light emitting stack IL of FIG. 8 may include the first stack layer IL1, the second stack layer IL2, and the third stack layer IL3 of FIG. 7.

Moreover, the encapsulation layer TFE of FIG. 8 may include the first encapsulation inorganic layer TFE1, the encapsulation organic layer TFE2, and the second encapsulation inorganic layer TFE3 of FIG. 7.

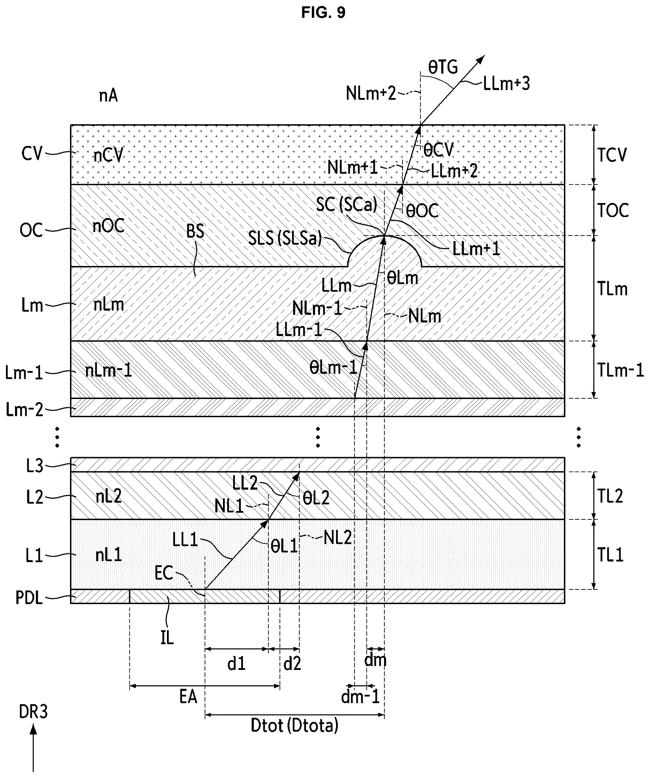

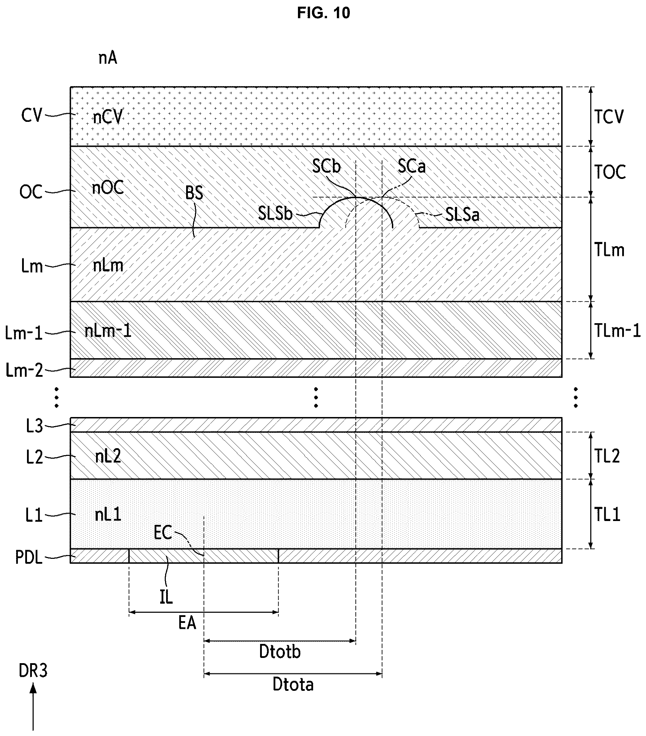

FIG. 9 is a cross-sectional view of a display device according to one embodiment for describing a shift amount of a sub-lens SLS. For example, FIG. 9 may be a cross-sectional view of a display device for describing the shift amount of a sub-lens SLS33 of one sub-pixel (e.g., the emission area EA33) of FIG. 8. FIG. 10 is a diagram for describing a final position of the sub-lens SLS.

As shown in FIG. 9, the light emitting stack IL may be located in the emission area EA of the pixel defining layer PDL. In this case, the pixel defining layer PDL and the light emitting stack IL may be located on the semiconductor substrate SSUB. In addition, a first electrode (e.g., the third anode electrode AND33 in FIG. 8) may be located to overlap the emission area EA between the semiconductor substrate SSUB and the pixel defining layer PDL. In addition, the light emitting stack IL may be located on the first electrode.

On the pixel defining layer PDL and the light emitting stack IL, m layers L1, L2, L3, ..., Lm-2, Lm-1, and Lm may be located. In this case, m may be a natural number greater than 1. For example, the first layer L1 may be located on the pixel defining layer PDL and the light emitting stack IL, the second layer L2 may be located on the first layer L1, the third layer L3 may be located on the second layer L2, ..., the (m-1)^{th} layer Lm-1 may be located on the (m-2)^{th} layer Lm-2, and the m^{th} layer Lm may be located on the (m-1)^{th} layer Lm-1.

The overcoat layer OC may be located on the m^{th} layer Lm.

The cover layer CV may be located on the overcoat layer OC.

The m^{th} layer Lm, which is the uppermost layer among the first to m^{th} layers L1 to Lm, may be a layer including the sub-lens SLS. For example, the m^{th} layer Lm may include the sub-lens SLS provided in the sub-optical layer of the sub-pixel. In other words, among the first to m^{th} layers L1 to Lm, the m^{th} layer Lm, which is closest to the overcoat layer OC, may include the sub-lens SLS. For example, the m^{th} layer Lm may include a base layer BS and the sub-lens SLS on the base layer BS. In this case, the base layer BS and the sub-lens SLS may contain the same material. In addition, the base layer BS and the sub-lens SLS may be formed integrally.

The first to (m-1)^{th} layers L1 to Lm-1 may include the encapsulation layer TFE, the adhesive layer ADL, and the color filters CF1, CF2, and CF3 described above. For example, when the display device 10 includes three layers (e.g., the first, second, and third layers L1, L2, and L3) between the emission area EA of the pixel defining layer PDL and the m^{th} layer Lm, the first layer L1 may be the encapsulation layer TFE, the second layer L2 may be the adhesive layer ADL, and the third layer L3 may be a color filter (any one of the color filters CF1, CF2, and CF3). In this case, the color filter may not be shifted. For example, according to the embodiment shown in FIG. 9, the sub-lens SLS of the sub-pixel may be shifted but the color filter of the sub-pixel may not be shifted.

The shift amount (or movement amount or lateral movement amount) of the sub-lens SLS of the sub-pixel may be defined as a distance Dtot between a center portion EC of the emission area EA of the sub-pixel and a center SC of the sub-lens SLS in a lateral direction. Here, the "lateral direction" is defined as a direction perpendicular to the thickness direction (i.e., third direction DR3) of the semiconductor substrate SSUB or a direction parallel to a major surface of the semiconductor substrate SSUB. In this case, the center portion EC of the emission area EA may correspond to the center of gravity (e.g., the geometric center of gravity) of the emission area EA in a plan view, and the center SC of the sub-lens SLS may correspond to the center of gravity (e.g., the geometric center of gravity) of the sub-lens SLS in a plan view. In another embodiment, the center portion EC of the emission area EA may correspond to the geometric center of the emission area EA in a plan view, and the center SC of the sub-lens SLS may correspond to the geometric center of the sub-lens SLS in a plan view.

The shift amount of the sub-lens SLS may be the sum of movement amounts (e.g., lateral movement amounts) of lights in the respective layers of the light emitting stack IL (e.g., the organic light emitting layer of the light emitting stack IL). For example, the shift amount of the sub-lens SLS may be the sum of a lateral movement amount d1 of first light LL1 in the first layer L1, a lateral movement amount d2 of second light LL2 in the second layer L2, a lateral movement amount d3 of third light LL3 in the third layer L3, ... , the lateral movement amount dm-2 of (m-2)^{th} light LLm-2 in the (m-2)^{th} layer Lm-2, the lateral movement amount dm-1 of (m-1)^{th} light LLm-1 in the (m-1)^{th} layer Lm-1, and the lateral movement amount dm of m^{th} light LLm in the m^{th} layer Lm. In this case, the lateral movement amount may be a movement amount in a parallel direction (e.g., the first direction DR1 or the second direction DR2) to one major surface of the semiconductor substrate SSUB (e.g., the top surface or the bottom surface of the semiconductor substrate SSUB).

The lateral movement amount of light in each of layers L1 to Lm, OC, and CV may be calculated based on an angle at which the light from the corresponding layer is incident to another layer adjacent to the corresponding layer and the thickness of the corresponding layer. For example, the lateral movement amount d1 of the first light LL1 in the first layer L1 may be calculated based on an incident angle θL1 of the first light LL1 and a thickness TL1 of the first layer L1, the lateral movement amount d2 of the second light LL2 in the second layer L2 may be calculated based on an incident angle θL2 of the second light LL2 and a thickness TL2 of the second layer L2, the lateral movement amount d3 of the third light LL3 in the third layer L3 may be calculated based on an incident angle θL3 of the third light LL3 and a thickness TL3 of the third layer L3, ..., the lateral movement amount dm-2 of the (m-2)^{th} light LLm-2 in the (m-2)^{th} layer Lm-2 may be calculated based on an incident angle θLm-2 of the (m-2)^{th} light LLm-2 and a thickness TLm-2 of the (m-2)^{th} layer Lm-2, the lateral movement amount dm-1 of the (m-1)^{th} light LLm-1 in the (m-1)^{th} layer Lm-1 may be calculated based on an incident angle θLm-1 of the (m-1)^{th} light LLm-1 and a thickness TLm-1 of the (m-1)^{th} layer Lm-1, the lateral movement amount dm of the m^{th} light LLm in the m^{th} layer Lm may be calculated based on an incident angle θLm of the m^{th} light LLm and a thickness TLm of the m^{th} layer Lm, the lateral movement amount of the (m+1)^{th} light LLm+1 in the overcoat layer OC may be calculated based on an incident angle θOC of the (m+1)^{th} light LLm+1 and a thickness TOC of the overcoat layer OC, and the lateral movement amount of the (m+2)^{th} light LLm+2 in the cover layer CV may be calculated based on an incident angle θCV of the (m+2)^{th} light LLm+2 and a thickness TCV of the (m+2)^{th} layer Lm+2.

The thickness of each of the layers L1 to Lm, OC, and CV may be a size in a direction from the semiconductor substrate SSUB toward the cover layer CV (e.g., the third direction DR3). In this case, the thickness TLm of the m^{th} layer Lm, which is the uppermost layer (e.g., a layer including the sub-lens SLS) among the first to m^{th} layers L1 to Lm, may be defined as the sum of the thickness of the base layer BS and the thickness of the center SC of the sub-lens SLS overlapping the base layer BS. In other words, the thickness TLm of the m^{th} layer Lm may be defined as the sum of the thickness of the base layer BS and the thickness of the sub-lens SLS (e.g., the thickness of the center SC). The thickness TOC of the overcoat layer OC may be defined as a thickness from the center SC of the sub-lens SLS to the top surface of the overcoat layer OC as shown in FIG. 9. In addition, the incident angle of each light may be defined as an angle between each light and an imaginary normal line extending parallel to the third direction DR3.

Specifically, the lateral movement amount of light in each of layers L1 to Lm, OC, and CV may be defined as the product of a tangent value for the incident angle of light in the corresponding layer and the thickness of the corresponding layer. For example, the lateral movement amount d1 of the first light LL1 may be defined by Equation 1 below. $d 1 = TL 1 * tan \left(θL1\right)$

In Equation 1 above, 'd1' refers to the lateral movement amount d1 of the first light LL1 incident from the first layer L1 to the second layer L2, 'TL1' refers to the thickness TL1 of the first layer L1, and 'θL1' is the incident angle of the first light LL1 incident from the first layer L1 to the second layer L2 (e.g., the incident angle of the first light LL1 in the first layer L1). In this case, the incident angle θL1 of the first light LL1 may be an angle between a normal line NL1 and the first light LL1 from the first layer L1 toward the interface between the first layer L1 and the second layer L2.

The incident angle of each light may be calculated based on the refractive index of the corresponding layer through which the light passes, the refractive index of another layer adjacently located on the corresponding layer, and the incident angle of light passing through the another layer. In this case, the incident angle of light in the another layer may be calculated based on a target emission angle θTG of the sub-pixel. For example, the target emission angle θTG is an angle with respect to emission light LLm+3 of the sub-pixel, which is emitted from the cover layer CV of the display panel 100 to the outside of the display panel 100, and may be preset for each sub-pixel. Therefore, the incident angle θCV of the (m+2)^{th} light LLm+2 in the cover layer CV may be calculated based on the target emission angle θTG of the sub-pixel, the incident angle θOC of the (m+1)^{th} light LLm+1 may be calculated based on the incident angle θCV of the (m+2)^{th} light LLm+2, the incident angle θLm of the m^{th} light LLm may be calculated based on the incident angle θOC of the (m+1)^{th} light LLm+1, the incident angle θL(m-1) of the (m-1)^{th} light LLm-1 may be calculated based on the incident angle θLm of the m^{th} light LLm, ..., the incident angle θL2 of the second light LL2 may be calculated based on the incident angle θL3 of the third light LL3, and the incident angle θL1 of the first light LL1 may be calculated based on the incident angle θL2 of the second light LL2.

For example, the incident angles of the lights may each be calculated by Equation 2 below based on Snell's law. $\begin{matrix}\left(1\right) θCV = {sin}^{- 1} \left(\left(nA*sinθTG\right)/nCV\right) \\ \left(2\right) θOC = {sin}^{- 1} \left(\left(nCV*sinθCV\right)/nOC\right) \\ \left(3\right) θLm = {sin}^{- 1} \left(\left(nOC*sinθOC\right)/nLm\right) \\ \left(4\right) θLm - 1 = {sin}^{- 1} \left(\left(nLm*sinθLm\right)/nLm-1\right) \\ \left(5\right) θL 2 = {sin}^{- 1} \left(\left(nL3*sinθL3\right)/nL2\right) \\ \left(6\right) θL 1 = {sin}^{- 1} \left(\left(nL2*sinθL2\right)/nL1\right)\end{matrix}$

In (1) of Equation 2 above, 'θCV' is the incident angle of the (m+2)^{th} light LLm+2 incident from the cover layer CV to the interface between the cover layer CV and the air layer, 'θTG' is the selected target emission angle of the sub-pixel, 'nA' is the refractive index of the air layer, and 'nCV' is the refractive index of the cover layer CV. In this case, the incident angle θCV of the (m+2)^{th} light LLm+2 may be defined by an angle between an (m+2)^{th} normal line NLm+2 (e.g., the normal line that intersects the (m+2)^{th} light LLm+2) and the (m+2)^{th} light LLm+2 incident from the cover layer CV to the interface between the cover layer CV and the air layer.

In (2) of Equation 2 above, 'θOC' is the incident angle of the (m+1)^{th} light LLm+1 incident from the overcoat layer OC to the interface between the overcoat layer OC and the cover layer CV, and 'nOC' is the refractive index of the overcoat layer OC. In this case, the incident angle θOC of the (m+1)^{th} light LLm+1 may be defined by an angle between the (m+1)^{th} light LLm+1 incident from the overcoat layer OC to the interface between the overcoat layer OC and the cover layer CV and an (m+1)^{th} normal line NLm+1 (e.g., the normal line that intersects the (m+1)^{th} light LLm+1).

In (3) of Equation 2 above, 'θLm' is the incident angle of the m^{th} light LLm incident from the m^{th} layer Lm (e.g., the layer including the sub-lens SLS) to the interface between the m^{th} layer Lm (e.g., the sub-lens SLS) and the overcoat layer OC, and 'nLm' is the refractive index of the m^{th} layer Lm. In this case, the incident angle θLm of the m^{th} light LLm may be defined by an angle between the m^{th} light LLm incident from the m^{th} layer Lm to the interface between the m^{th} layer Lm and the overcoat layer OC and an m^{th} normal line NLm (e.g., the normal line that intersects the m^{th} light LLm). Further, the m^{th} light LLm may be light that passes through the base layer BS of the m^{th} layer Lm and is incident to the center SC of the sub-lens SLS of the m^{th} layer Lm.

In (4) of Equation 2 above, 'θLm-1' is the incident angle of the (m-1)^{th} light LLm-1 incident from the (m-1)^{th} layer Lm-1 to the interface between the (m-1)^{th} layer Lm-1 and the m^{th} layer Lm, and 'nLm-1' is the refractive index of the (m-1)^{th} layer Lm-1. In this case, the incident angle θLm-1 of the (m-1)^{th} light LLm-1 may be defined by an angle between the (m-1)^{th} light LLm-1 incident from the (m-1)^{th} layer Lm-1 to the interface between the (m-1)^{th} layer Lm-1 and the m^{th} layer Lm and an (m-1)^{th} normal line NLm-1 (e.g., the normal line that intersects the (m-1)^{th} light LLm-1).

In (5) of Equation 2 above, 'θL2' is the incident angle of the second light LL2 incident from the second layer L2 to the interface between the second layer L2 and the third layer L3, and 'nL2' is the refractive index of the second layer L2.

In (6) of Equation 2 above, 'θL1' is the incident angle of the first light LL1 incident from the first layer L1 to the interface between the first layer L1 and the second layer L2, and 'nL1' is the refractive index of the first layer L1.

When the incident angle θCV of the (m+2)^{th} light LLm+2 is calculated through the previously known target emission angle θTG and (1) of Equation 2, the incident angle θOC of the (m+1)^{th} light LLm+1, the incident angle θLm of the m^{th} light LLm, the incident angle θLm-1 of the (m-1)^{th} light LLm-1, ..., the incident angle θL2 of the second light LL2 and the incident angle θL1 of the first light LL1 may be calculated, respectively, through (2) to (6) of Equation 2 above.

As described above, after the incident angles θL1 to θLm of the first to m^{th} lights LL1 to LLm in the first to m^{th} layers L1 to Lm are calculated, the lateral movement amounts d1 to dm of the first to m^{th} lights LL1 to LLm may be calculated based on the incident angles θL1 to θLm of the first to m^{th} lights LL1 to LLm. For example, based on Equation 1 above, the lateral movement amount d1 of the first light LL1 in the first layer L1, the lateral movement amount d2 of the second light LL2 in the second layer L2, ..., the lateral movement amount dm-1 of the (m-1)^{th} light LLm-1 in the (m-1)^{th} layer Lm-1 and the lateral movement amount dm of the m^{th} light LLm in the m^{th} layer Lm may be calculated, respectively.

Thereafter, the lateral movement amounts d1 to dm of the first to m^{th} lights LL1 to LLm are all added up to calculate a total lateral movement amount Dtot. Then the total lateral movement amount Dtot may be multiplied by a correction value α to calculate the final movement amount of the sub-lens SLS in the corresponding sub-pixel. For example, a final movement amount SHT_SLS_SP(i, j) of the sub-lens SLS (or a final shift amount of the sub-lens SLS) included in the sub-pixel of specific two-dimensional coordinates may be defined as Equation 3 below. $SHT _ SLS _ SP \left(i, j\right) = α \times {\sum }_{k = 1}^{m} \left(TLk\times tan\left(θLk\right)\right)$

In Equation 3 above, 'SHT_SLS_SP(i, j)' refers to the final movement amount of the sub-lens SLS of the sub-pixel located in the two-dimensional plane coordinates (i, j) set in the first direction DR1 and the second direction DR2, 'α' refers to a correction value, 'TLk' refers to a thickness of a k^{th} layer, and 'θLk' refers to an incident angle of k^{th} light incident from the k^{th} layer to a (k+1)^{th} layer (e.g., the incident angle of k^{th} light in the k^{th} layer). In this case, k is a natural number and may have any value from 1 to m.

The correction value α may have a value of, for example, 0.85 to 0.90. Accordingly, as shown in FIG. 10, a sub-lens SLSb of a sub-pixel may be located closer to the center of the emission area EA of the sub-pixel than the sub-lens SLS (or SLSa) of the sub-pixel of FIG. 9. In other words, the final position of the sub-lens SLSb of the sub-pixel calculated based on Equation 3 may be determined as the point shown in FIG. 10. For example, the position of the sub-lens SLSa (e.g., the position of a center SCa of the sub-lens SLSa) in FIG. 9 may be calculated based on the target emission angle θTG preset according to the coordinates of the sub-pixel. The position of the sub-lens SLSb in FIG. 10 may be set by the product of the correction value α and the distance between the center portion EC of the emission area EA and the center SC (or SCa) of the sub-lens SLSa in FIG. 9 (e.g., the sum of the lateral movement amounts d1 to dm of the first to m^{th} lights LL1 to LLm set based on the first to m^{th} layers L1 to Lm including the sub-lens SLSa in FIG. 9). In FIG. 9, the position of the sub-lens SLSa may be the position of the imaginary sub-lens SLSa. In FIG. 10, the position of the sub-lens SLS may be the final position of the real sub-lens SLSb.

For example, when the position of the center SC (or SCa) of the sub-lens SLS in FIG. 9 is defined as a preliminary position and the position of a center SCb of the sub-lens SLS in FIG. 10 is defined as the final position, the final position of the sub-lens SLSb may be set to a position corresponding to a value obtained by multiplying the preliminary position of the sub-lens SLSa by the correction value α. In other words, when the distance between the center portion EC of the emission area EA and the preliminary position of the sub-lens SLSa is defined as a preliminary distance Dtota, and the distance between the center portion EC of the emission area EA and the final position of the sub-lens SLSb is defined as a final distance Dtotb, the final distance Dtotb may be set to a value obtained by multiplying the preliminary distance Dtota (e.g., the sum of the lateral movement amounts d1 to dm of the first to m^{th} lights LL1 to LLm set based on the first to m^{th} layers L1 to Lm including the sub-lens SLSa in FIG. 9) by the above-described correction value α.

For example, in accordance with a method for calculating the final distance Dtotb (e.g., the shift amount) of the sub-lens SLSb of the display device 10 according to one embodiment, it may be calculated by calculating the distance Dtota (e.g., the preliminary distance) between the imaginary sub-lens SLSa (e.g., the center SCa of the imaginary sub-lens SLSa) at the preliminary position and the center portion EC of the emission area EA, and multiplying the preliminary distance Dtota by the correction value α. In this case, the preliminary distance Dtota may be the sum of the lateral movement amounts d1 to dm of the first to m^{th} lights LL1 to LLm in the first to m^{th} layers L1 to Lm when the sub-lens SLS is located at the preliminary position. For example, the preliminary distance Dtota may be the sum of the lateral movement amounts d1 to dm of the first to m^{th} lights LL1 to LLm calculated based on the imaginary sub-lens SLSa.

According to one embodiment, since the distance between the emission area EA of the sub-pixel and the sub-lens SLS (e.g., the shift amount of the sub-lens SLS) is optimized by the correction value α, the emission angle of light emitted from the sub-pixel to the outside of the display panel 100 (e.g. cover layer CV) may be optimized. Accordingly, more light may be emitted from each sub-pixel of the display panel 100 at the emission angle of each sub-pixel, so that the luminance of the display panel 100 may be improved.

The display device 10 according to the embodiment may be applied to various electronic devices. An electronic device according to one embodiment may include the above-described display device 10, and may further include, in addition to the display device 10, a module or device having other additional functions.

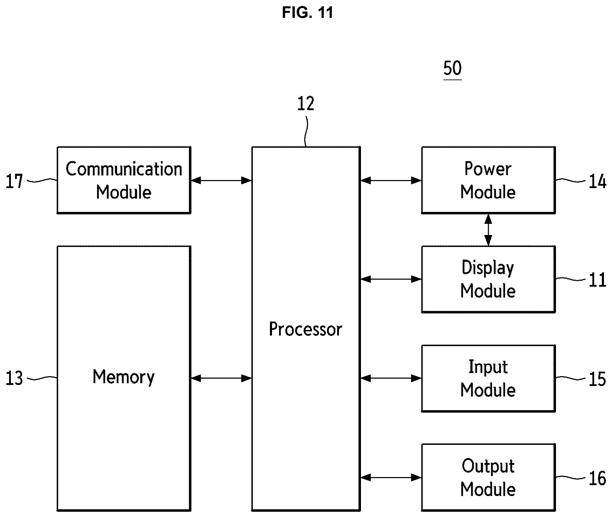

FIG. 11 is a block diagram of an electronic device according to one embodiment. Referring to FIG. 11, an electronic device 50 according to one embodiment may include a display module 11, a processor 12, a memory 13, and a power module 14. The electronic device 50 may further include an input module 15, a non-visual output module 16, and/or a communication module 17.

The electronic device 50 may output various information in the form of images through the display module 11. When the processor 12 executes an application stored in the memory 13, image information provided by the application may be provided to a user through the display module 11. The power module 14 may include a power supply module, such as a power adapter or a battery device, and a power conversion module that converts the power supplied by the power supply module to generate the power required for the operation of the electronic device 50. The input module 15 may provide input information to the processor 12 and/or the display module 11. The non-visual output module 16 may serve to receive information other than images, such as sound, haptics, luminescence, etc., sent from the processor 12, and provide it to the user. The communication module 17 is a module responsible for the transmission and reception of information between the electronic device 50 and an external device, and may include a receiver and a transmitter.

At least one of each of the components of the above-described electronic device 50 may be included in the display device according to the embodiments described above. Further, some of individual modules functionally included in one module may be included in the display device and some others may be provided separately from the display device. For example, the display device may include the display module 11, and the processor 12, the memory 13, and the power module 14 may be provided in the form of other devices in the electronic device 10 other than the display device.

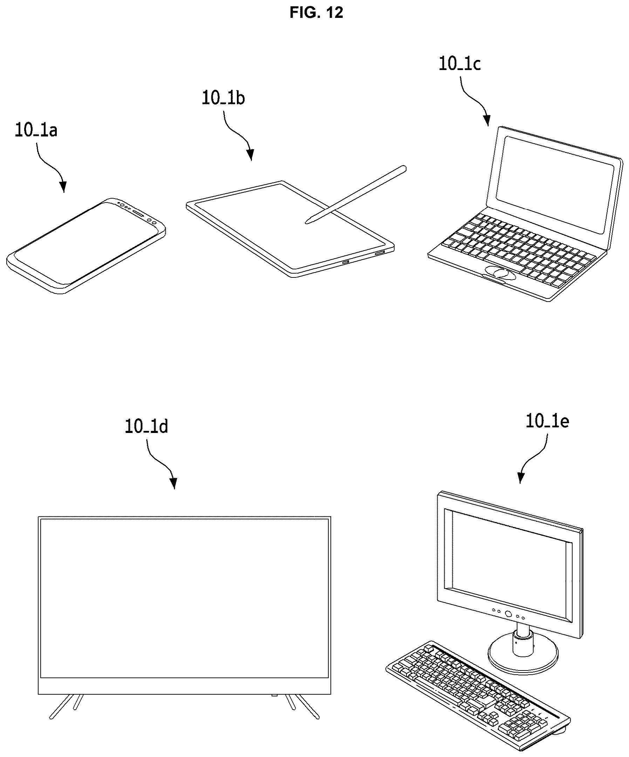

FIGS. 12, 13 and 14 are schematic diagrams illustrating electronic devices according to various embodiments. FIGS. 12 to 14 illustrate examples of various electronic devices to which the display device 10 according to the embodiments are applied.

FIG. 12 shows a smartphone 10_1a, a tablet PC 10_1b, a laptop 10_1c, a TV 10_1d, and a desk monitor 10_1e as examples of electronic devices.

The smartphone 10_1a may include a communication module and an input module such as a touch sensor, etc., in addition to the display module 11. The smartphone 10_1a may process the information received through the communication module or input module and display the processed information through the display module of the display device.

Each of the tablet PC 10_1b, the laptop 10_1c, the TV 10_1d, and the desk monitor 10_1e may include a display and an input module, similarly to the smartphone 10_1a, and may further include a communication module in some cases.

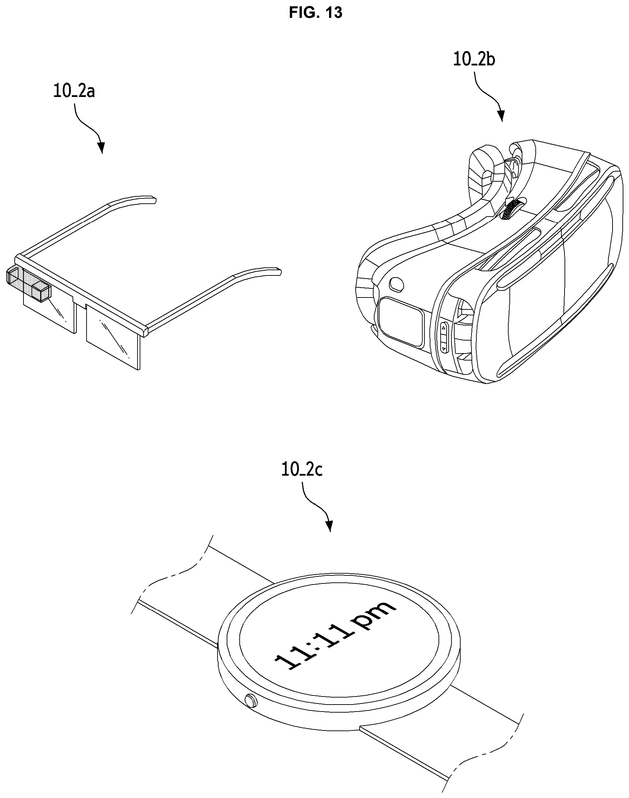

FIG. 13 illustrates a case in which an electronic device including a display module is applied to a wearable electronic device. The wearable electronic device may be smart glasses 10_2a, a head mounted display 10_2b, a smart watch 10_2c, and the like.

The smart glasses 10_2a and the head mounted display 10_2b may include a display module that outputs a display image and a reflector that reflects the outputted display image to provide it to the user's eyes, thereby providing the user with a virtual reality or augmented reality screen.

The smart watch 10_2c may include a biometric sensor as an input device, and may provide biometric information recognized through the biometric sensor to the user through a display module.

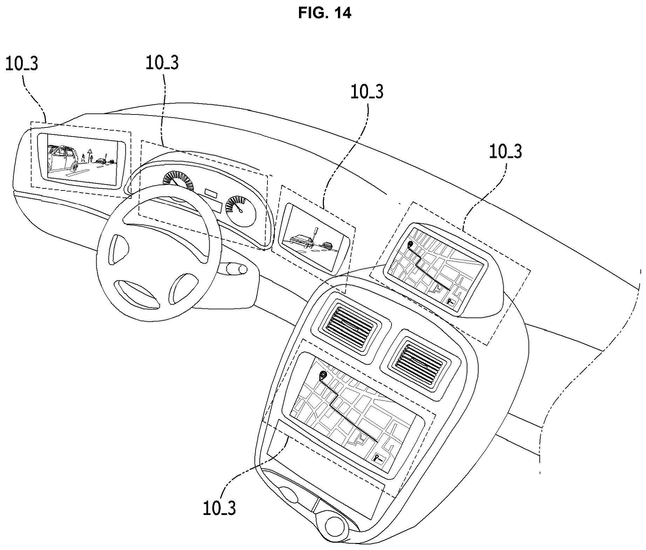

FIG. 14 illustrates a case in which an electronic device including a display module is applied to a vehicle. For example, an electronic device 10_3 may be applied to a dashboard or center fascia of a vehicle, or to a center information display (CID) placed in the dashboard of the vehicle or a room mirror display that replaces a side mirror.

In concluding the detailed description, those skilled in the art will appreciate that many variations and modifications can be made to the preferred embodiments without substantially departing from the principles of the present invention as defined by the appended claims. Therefore, the disclosed preferred embodiments of the invention are used in a generic and descriptive sense only and not for purposes of limitation.

## Claims

1. A display device (10) comprising:
a substrate (SSUB);
a first electrode (AND) on the substrate (SSUB);
a pixel defining layer (PDL) located on the first electrode (AND) and having an emission area (EA) exposing the first electrode (AND);
a light emitting stack (IL) located on the emission area (EA);
first to m^{th} layers (L1 - Lm) sequentially arranged on the light emitting stack (IL) and the pixel defining layer (PDL);
an overcoat layer (OC) located on the m^{th} layer (Lm); and
a cover layer (CV) located on the overcoat layer (OC),
wherein the m^{th} layer (Lm) comprises a sub-lens (SLS), and
the m is a natural number greater than 1, and
a final distance (Dtotb) from a center portion (EC) of the emission area (EA) to a center (SC) of the sub-lens (SLS) in a lateral direction has a value calculated based on a preset correction value and a sum of lateral movement amounts of first to m^{th} lights (LL1 - LLm) in the first to m^{th} layers (L1 - Lm) when the sub-lens (SLS) is located at a preliminary position (Dtota).

2. The display device (10) of claim 1, wherein the final distance (Dtotb) from the center portion (EC) of the emission area (EA) to the center (SC) of the sub-lens (SLS) has a value of a product of the preset correction value and the sum of the lateral movement amounts of the first to m^{th} lights (LL1 - LLm) when the sub-lens (SLS) is located at the preliminary position (Dtota).

3. The display device (10) of claim 1 or 2, wherein the preset correction value is 0.85 to 0.90.

4. The display device (10) of any one of the preceding claims, wherein a lateral movement amount (dk) of k^{th} light (LLk) in a k^{th} layer (Lk) has a value of a product of a thickness of the k^{th} layer (Lk) and a tangent value for an incident angle (θLk) of the k^{th} light (LLk) in the k^{th} layer (Lk), and
the k is a natural number having any value from 1 to m.

5. The display device (10) of claim 4, wherein the lateral movement amount (dk) of the k^{th} light (LLk) is a lateral movement amount (dk) of the k^{th} light (LLk) traveling from a bottom surface to a top surface of the k^{th} layer (Lk).

6. The display device (10) of claim 4 or 5, wherein the incident angle (θLk) of the k^{th} light (LLk) is an angle between a direction of the k^{th} light (LLk) and a direction perpendicular to the lateral direction.

7. The display device (10) of any one of claims 4 to 6, wherein the incident angle (θLk) of the k^{th} light (Lk) has a value calculated based on a target emission angle (θTG) of an emission light emitted from the cover layer (CV) to an outside of the cover layer (CV), refractive indices of the k^{th} to m^{th} layers (Lk - Lm), and incident angles of (k+1)^{th} to m^{th} lights (LLk+1 - LLm) in the (k+1)^{th} to m^{th} layers (Lk+1 - Lm).

8. The display device (10) of any one of the preceding claims, wherein the m^{th} layer (Lm) comprises:
a base layer (BS); and
the sub-lens (SLS) located on the base layer (BS).

9. The display device (10) of claim 8, wherein a thickness of the m^{th} layer (Lm) is a sum of a thickness of the base layer (BS) and a thickness of the sub-lens (SLS) at the center (SC) of the sub-lens (SLS).

10. The display device (10) of any one of the preceding claims, further comprising a second electrode (CAT) located between the light emitting stack (IL) and the first layer (L1).

11. The display device (10) of any one of the preceding claims,
wherein the first to the m^{th} layers (L1 - Lm) have different refractive indices; and/or
wherein the first to the m^{th} layers (L1 - Lm), the overcoat layer (OC) and the cover layer (CV) have different refractive indices.

12. The display device (10) of any one of the preceding claims,
wherein the substrate (SSUB) is a semiconductor substrate (SSUB); and/or
wherein the first to the m^{th} layers (L1 - Lm) comprise an encapsulation layer (TFE), an adhesive layer (ADL) on the encapsulation layer (TFE), and a color filter (CF) on the adhesive layer (ADL).

13. The display device (10) of any one of the preceding claims,
wherein the sub-lens (SLS) is a micro-lens; and/or
wherein the display device (10) further comprises a lens (777) on the cover layer (CV).

14. An electronic device (10, 50) comprising:
a display device (10) according to any one of the proceeding claims, providing a screen.

15. The electronic device (10, 50) of claim 14, wherein the electronic device (10, 50) comprises a smartphone (10_1a), a tablet PC (10_1b), a laptop (10_1c), a TV (10_1d), a desk monitor (10_1e), smart glasses (10_2a), a smart watch (10_2c), a head mounted display (10_2b) and a vehicle.
